# EUROPEAN PATENT SPECIFICATION

(11) **EP 1 495 838 B1**
(45) Date of publication and mention of the grant of the patent: **17.10.2007**
(21) Application number: 04014353.9
(22) Date of filing: 15.03.2000
(51) Int. Cl.: B24B 37/04, B24B 41/06, B24B 57/02

(54) **Wafer polishing apparatus and method for manufacturing wafer**
Waferpoliervorrichtung und -verfahren
Dispositif de polissage de plaquette semiconductrice et procédé de fabrication de plaquette semiconductrice

(30) Priority: 15.03.1999 JP 6933699; 15.03.1999 JP 6933799; 15.03.1999 JP 6933899; 14.05.1999 JP 13501999
(43) Date of publication of application: 12.01.2005
(62) Divisional of application: 00105312.3
(73) Proprietor: EBARA CORPORATION, Tokyo 144-8510 (JP)
(72) Inventor: Kobayashi, Tatsunori, Central Research Institute, Omiya-shi Saitama-ken (JP); Tanaka, Hiroshi, Central Research Institute, Omiya-shi Saitama-ken (JP); Kajiwara, Jiro, Minuma-ku,Saitama-shi, Saitama-ken (JP)
(74) Representative: HOFFMANN EITLE

(56) References cited:
- EP-A- 0 770 454
- EP-A- 0 870 576
- FR-A- 2 767 735
- GB-A- 2 315 694
- PATENT ABSTRACTS OF JAPAN vol. 1997, no. 07, 31 July 1997 (1997-07-31) -& JP 09 057612 A (NEC CORP), 4 March 1997 (1997-03-04)

## Description

### BACKGROUND OF THE INVENTION

### 1. Field of the Invention

The present invention relates to a wafer transfer apparatus for delivering a wafer to be polished to a wafer holding head and for receiving a polished wafer from the wafer holding head. The present invention also relates to a wafer polishing apparatus to be used for an apparatus for polishing the surface of a semiconductor wafer, and a method for manufacturing the wafer.

### 2. Description of the Related Art

Fine patterning of semiconductor wafers has been developed in recent years as a result of development of highly integrated semiconductor devices. Since fine patterning of the wafers having multilayer structures have been made easy and secure, it is particularly important to planarize the surface of semiconductor wafers as fine as possible in the manufacturing process. Finer planarization of the surface of the semiconductor wafers allows patterning precision to be improved besides making focusing of the exposed light easy when a photolithographic process is used for patterning. In addition, production of the semiconductor wafers can enjoy a low cost because the work efficiency is improved without providing complicated equipments for manufacturing the semiconductor wafers.

A chemical-mechanical polishing method (a CMP method) has been highlighted for this purpose since the method can polish the surface film with a high degree of planarity.

The surface of wafers are mechanically and chemically polished and planarized using an alkaline slurry containing SiO₂, a neutral slurry containing SeO₂, an acidic slurry containing Al₂O₃, or a slurry containing other abrasive (these are simply referred as a slurry hereinafter) in the CMP method. A wafer holding head for holding the wafer (a wafer holding head) and a polishing pad are usually disposed in opposed relation with each other in the wafer polishing apparatus for polishing the surface of the wafer, and the wafer is polished by allowing the wafer polishing head to rotate on the polishing pad by pressing the surface of the wafer onto the polishing pad while feeding a slurry.

Although it is desirable that the polishing pad is as planar as possible, its surface is deteriorated to cause decrease of polishing ability (polishing rate) by using it for polishing the wafer, or polishing performance (uniformity of polishing or degree of distribution of the thickness of the remaining film on the wafer) is decreased by causing a little roughness or inclination on the surface of the polishing pad, due to uneven abrasion or clogging of the pad after polishing. Therefore, the polishing pad is subjected to reforming (dressing) for restoring the polishing performance of the polishing pad, by allowing the polishing pad after finishing a wafer polishing process to rotate while allowing its surface to contact a dresser.

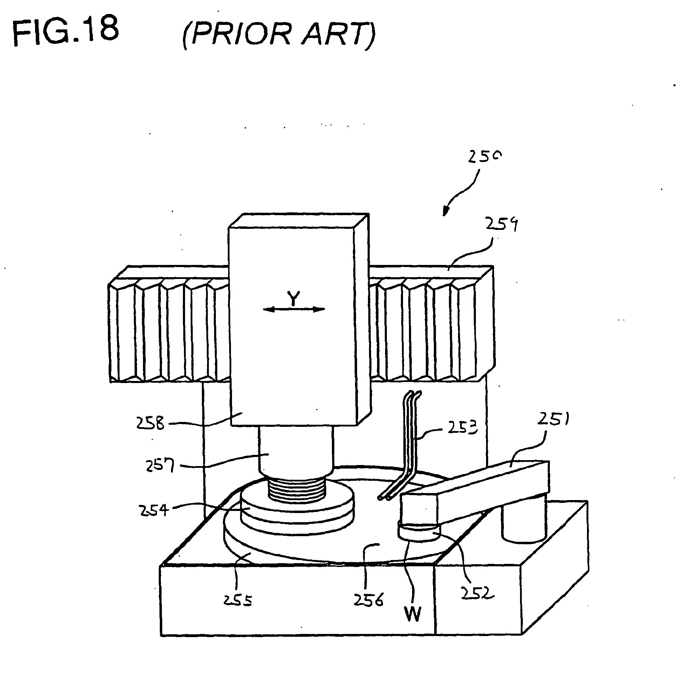

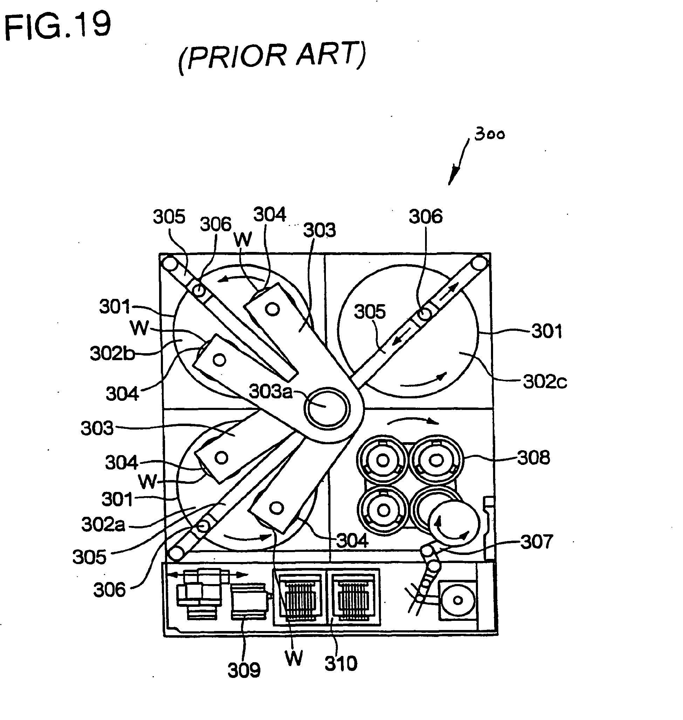

The polishing process may be simultaneously carried out with the dressing process as shown in FIGs. 18 and 19. In the first conventional example shown in FIG. 18, the wafer polishing apparatus **250** is provided with a wafer holding head **252** attached at the tip of an arm **251** supported to be able to freely pivot, a slurry feed means **253** for feeding a slurry to a polishing pad **256**, and a dresser **254**. The slurry feed device **253** directly feeds the slurry to the polishing pad **256** affixed on the surface of a platen **255**, and the wafer **W** held on the wafer holding head **252** is polished by allowing the wafer **W** to rotate while making contact with the surface of the polishing pad **256**. The dresser **254** is, on the other hand, held in rotatable manner with a driving mechanism **257**, which is supported on a base **258**. The base **258** is also supported to be linearly slidable along the direction indicated by an arrow **Y** with a guide member **259**. The dresser **254** dresses the surface of the polishing pad **256** that has a deteriorated polishing performance after polishing the wafer **W**. The wafer is polished at a different site from the site for dressing the wafer on the polishing pad **256**.

In the second conventional example shown in FIG. 19, the wafer polishing apparatus **300** is provided with three rotatable platens **301** and polishing pads **302** affixed on their surfaces, wafer holding heads **304** provided at the tips of respective two branched arms **303**, and dressers **306** that are able to linearly slide along guide members **305** provided along the radial direction of each polishing pad **302**. The arm **303** is supported with a pivot **303a** to be able to freely pivot, and the wafers supported with the wafer holding heads **304** are polished with respective polishing pads **302**. The surface of the polishing pad **302** is dressed with the dresser **306** that is slidable along the radial direction of the polishing pad **302**, while simultaneously polishing the wafer.

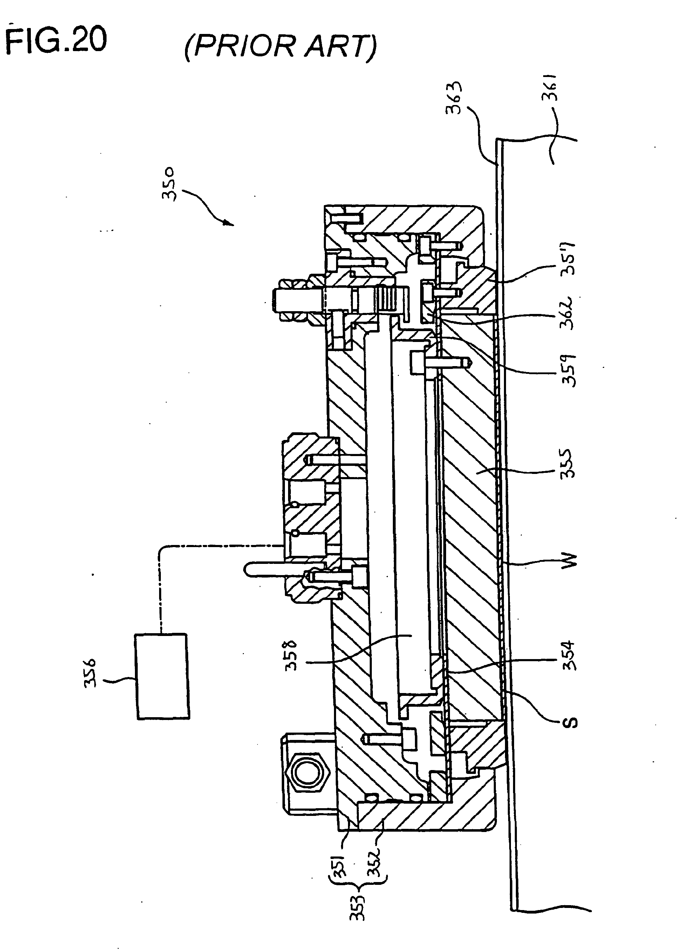

The third conventional example of the wafer polishing apparatus comprises an apparatus using a wafer holding head **350** as shown in FIG. 20.

In FIG. 20, the wafer holding head **350** is provided with a head body **353** comprising a top plate **351** and a cylindrical circumference wall **352** fixed to the circumference of the top plate **351**, a diaphragm **354** expanded in the head body **353** and comprising an elastic material such as a rubber, a pressure adjustment mechanism **356** for adjusting the pressure in a fluid chamber **358**, a disk-shaped carrier **355** fixed on the lower face of the diaphragm **354**, and a ring-shaped retainer ring **357** disposed in concentric relation to the outer circumference of the carrier **355**.

The carrier **355** and the retainer ring **357** are fixed on a carrier fixing ring **359** and a retainer ring fixing ring **362**, respectively, provided on the upper face of the diaphragm **354**. The retainer ring **357** is disposed in concentric relation with a slight gap between the outer circumference face of the carrier **355** and the circumference wall **352**. The slight gap is provided for suppressing the displacement range of the retainer ring **357** along the radial direction from being too large due to elastic deformation of the diaphragm **354**.

The wafer W is affixed on a wafer affix sheet S (an insert) provided on the lower face of the carrier **355**, while the outer circumference of the wafer W being locked with the retainer ring **357**. The wafer is polished by allowing the wafer holding head **350** and the platen **361** to rotate causing a relative movement, when the slurry is fed onto the surface of the polishing pad **363** and the polishing face of the wafer **W** from outside of the wafer holding head **350**, while allowing the surface of the wafer **W** to contact the polishing pad **363** affixed on the upper face of the platen **361**.

The carrier **355** and the retainer ring **357** has a floating structure in which both members are able to independently displace along the ascending and descending directions by deformation of the diaphragm **354**. The pressing pressure of the carrier **355** and the retainer ring **357** onto the polishing pad **363** changes depending on the pressure in the fluid chamber 358 adjusted with pressure adjustment mechanism **356**.

While the wafer polishing apparatus as shown in the first and second conventional examples is effective for polishing the wafer, since the wafer polishing process and the dressing process can be simultaneously applied. However, when the wafer is polished with the wafer polishing apparatus as shown in the first conventional example, the slurry is directly fed onto the surface of the polishing pad **256** from outside of the wafer holding head **252**. Most of the fed slurry flows out by the centrifugal force applied to the rotating platen **255**, forcing to feed a large amount of the slurry for obtaining a sufficient polishing effect. A large amount of an expensive abrasive is wasted without effectively using the slurry. In addition, the polishing debris generated by polishing has been washed out by feeding the slurry on the surface of the polishing pad, also wasting a large amount of the slurry to make the removing method to be high cost with poor efficiency. This problem is common in the wafer polishing apparatus shown in the third conventional example.

Since the dresser **254** occupies a large installation area, a few numbers of wafers holding head **252** are attachable to decrease service efficiency of the apparatus.

In the second conventional example, the dresser **306** has a smaller size than the dresser **302**, and is linearly travels relative to the polishing pad **302**. Accordingly, it is difficult to uniformly press the entire polishing pad **302**, thereby planarization of the surface of the polishing pad **302** has been insufficient.

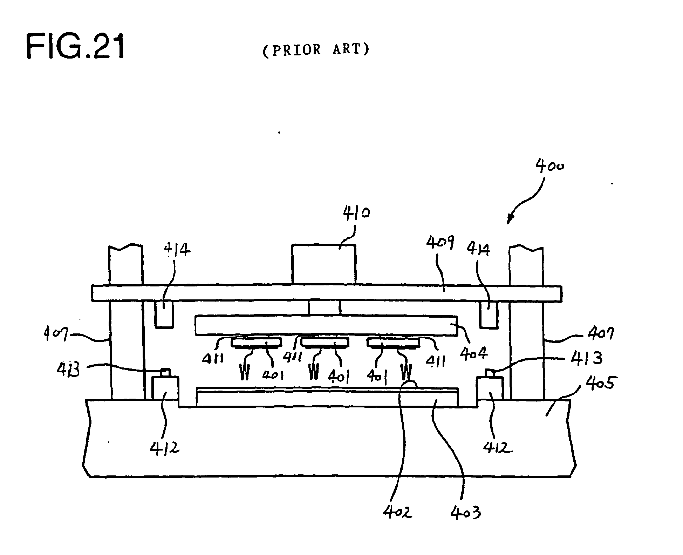

The fourth conventional example of the wafer polishing apparatus is shown in FIG. 21. The wafer polishing apparatus **400** is provided with a wafer holding head **401** for holding the wafer W to be polished, and a polishing pad **402** affixed on the entire upper face of the platen **403** formed into a disk shape. A plurality of the wafer holding heads **401** are mounted at the bottom of a carousel **404** as a head driving mechanism, which is supported with a spindle **411** and undergoes a planetary motion on the polishing pad **402**. It is possible to dispose the center of the platen **403** and the center of rotation of the wafer holding head **401** in eccentric relation with each other.

The platen **403** is horizontally disposed at the center of a base **405**, and rotates around the axis line with a platen driving mechanism provided in the base **405**. Guide posts **407** are provided at the side of the base **405**, and an upper mounting plate (bridge) **409** for supporting a carousel driving mechanism **410** is disposed among the guide posts **407**. The carousel driving mechanism **410** serves for allowing a carousel **404** provided below the device to rotate around the axis line.

Bridge supports **412** are disposed so as to protrude upward from the base **405**, and a gap adjustment mechanism **413** is provided on the tip of each bridge support **412**. A locking member **414** is disposed, on the other hand, above the bridge support **412** in an opposed relation with each other. The locking member **414** is fixed to the upper mounting plate (bridge) **409**, and protrude downward from the upper mounting plate (bridge) **409**. The space between the wafer holding head **401** and the polishing pad **402** is adjusted by adjusting the gap adjustment mechanism **413** to allow the bridge support **412** to contact the locking member **414**. The wafer **W** is polished by allowing the wafer held on the wafer holding head **401** to contact the surface of the polishing pad **402**, while allowing the carousel 404 and the platen **403** to rotate.

While a plurality of the wafer holding heads **401** holding the wafers **W** are provided, the position of the wafer holding head **401** sometimes finely shifts from the position of the polishing pad **402** affixed on the platen **403**, when the thickness of the polishing pad **402** has been reduced by polished, thereby causing a problem that uniformity and planarity of the wafer **W** become to be poor. However, adjusting the gap adjustment mechanism **413** every time is not only not practical, but also making it difficult to adjust the positioning of the wafer holding head and polishing pad to right and left in a µm unit using the gap adjustment mechanism **413**, while suffering the pressing pressure generated during polishing. Also, the positional shift is caused by dimensional changes of the wafer holding head **401**, thereby manufacturing excessively polished wafers and insufficiently polished wafers.

Polishing of the wafer **W** using the polishing apparatus shown in the second conventional example will be described hereinafter. In FIG. 19, the wafer **W** to be polished is held on each wafer holding head **304** provided at each tip of the two branched arms **303**. These wafers **W** are polished by rotation while they are allowed to contact each pad **302** (referred as respective polishing pads **302a, 302b**, and **302c** hereinafter) affixed on respective surfaces of three rotatable platens **301**. The polishing pads **302a** and **302b** serve as primary polishing pads, while the polishing pad **302c** serves as a secondary polishing pad. These polishing pads **302a, 302b** and **302c** are dressed with the dressers **306** being able to linearly shift with the guide members **305** provided along respective radial directions. The arm **303** is supported with the pivot **303a** to be able to freely pivot. The wafer **W** is subjected to secondary polishing with the polishing pad **302c**, after being subjected to primary polishing with the polishing pads **302a** and **302b**. The Wafer **W** is attached to and detached from the wafer holding head **304** with a flexible handling robot **307** at a wafer attaching and detaching station **308**. The handling robot **307** takes out a wafer **W** to be polished from a second cassette **309**, and attaches the wafer **W** to the wafer holding head **304** at the wafer attaching and detaching station **308**. The wafer **W** after completing polishing is detached from the wafer holding head **304** with the handling robot **307** at the wafer attaching and detaching station **308**, and transferred to a receiving cassette **310**.

Since the wafer is attached to and detached from the wafer holding head **304** with the flexible handling robot **307**, the construction of the handling robot **307** becomes complicated. Consequently, reliability of handling operation to the wafer **W** is compromised, or maintenance such as cleaning of the apparatus becomes difficult. Since flexible access range of the handling robot **307** should be enlarged for attaching and detaching a plurality of wafers **W** to the wafer holding head **304**, the handling robot **307** brings about to be large size and complicated, thereby slowing its operation to decrease operation efficiency.

While making the handling robot **307** itself as a wafer attaching-detaching member movable may be contemplated, it causes decrease of reliability and work efficiency because the overall apparatus is complicated, and positioning relative to the wafer holding head **304** becomes difficult.

EP0770454A1 and EP0870576A2 disclose polishing apparatus falling within the scope of the pre-characterizing portions of independent claims 1, 4 and 6.

### SUMMARY OF THE INVENTION

According to a first aspect of the present invention, there is provided a wafer polishing apparatus of comprising a platen; a polishing pad affixed on a surface of the platen; and a wafer holding head comprising a carrier, for allowing one face of a wafer (W) to contact the polishing pad by holding the wafer to be polished, the wafer being polished, in use of the apparatus, with the polishing pad by a relative motion between the wafer holding head and the platen, and a retainer ring which is provided so as to be displaceable along a head axis direction for locking a periphery of the wafer while making contact with the polishing pad during polishing of the wafer, characterized in that the water polishing apparatus, further comprises a slurry pocket, which is formed on a lower face of the retainer ring, for contacting the polishing pad and distributing a slurry equally; and a retainer ring tube formed in the retainer ring and communicating with a slurry feed member.

According to a second aspect of the present invention, there is provided a wafer polishing apparatus comprising a platen; a polishing pad affixed on a surface of the platen; a wafer holding head comprising a carrier for allowing one face of a wafer (W) to contact the polishing pad by holding the wafer to be polished, the wafer being polished, in use of the apparatus, with the polishing pad by a relative motion between the wafer holding head and the platen, a circumference wall forming part of a head body, and a retainer ring which is provided so as to be displaceable along a head axis direction for locking a periphery of the wafer while making contact with the polishing pad during polishing the wafer; and an outer ring which is disposed in concentric relation to the wafer holding head and is provided so as to be displaceable along the head axis direction, for making contact with the polishing pad during polishing at the outside of the wafer holding head, characterized in that the wafer polishing apparatus further comprises a slurry pocket which is formed between the retainer ring and the outer ring, for contacting the polishing pad and distributing the slurry equally; and a head body tube formed in the circumference wall, and communicating with a slurry feed member.

According to a third aspect of the present invention, there is provided a wafer polishing apparatus comprising a platen; a polishing pad affixed on a surface of the platen; and a wafer holding head for holding a wafer to be polished, and for allowing one face of the wafer to contact the polishing pad, the wafer being polished, in use of the apparatus, with the polishing pad by a relative motion between the wafer holding head and the platen, characterized in that the wafer polishing apparatus further comprises a slurry holding ring, which is allowed at its lower face to contact the polishing pad, which is disposed so as not to contact the periphery of the wafer holding head, and which is provided at the outside of the wafer holding head to be rotatable with respect to the wafer holding head; and a slurry feed member configured and arranged to feed a slurry between an outer circumference of the wafer holding head and an inner circumference of the slurry holding ring.

According to a fourth aspect of the present invention, there is provided a method for manufacturing a wafer comprising a step for providing a platen on a surface of which a polishing pad is affixed, a wafer holding head comprising a carrier for allowing one face of a wafer (W) to contact the polishing pad by holding the wafer to be polished, and a retainer ring for locking a periphery of the wafer while making contact with the polishing pad during polishing of the wafer, the retainer ring having a retainer ring tube formed therein communicating with a slurry feed member; and a polishing step for polishing the wafer with the polishing pad by a relative motion between the wafer holding head and the platen, characterized in that a slurry pocket, which is formed on a lower face of the retainer ring for feeding a slurry, is provided at the periphery of a wafer holding portion on a lower face of the wafer holding head; the wafer holding head is allowed to rotate while allowing the lower face of the wafer holding head to contact the polishing pad; and the wafer is polished by feeding a slurry onto the face of the wafer and a surface of the polishing pad while suppressing the slurry fed to the slurry pocket from flowing out.

According to a fifth aspect of the present invention, there is provided a method for manufacturing a wafer comprising a step for providing a platen on the surface of which a polishing pad is affixed, and a wafer holding head, comprising a carrier for allowing one face of a wafer to contact the polishing pad by holding the wafer to be polished and a retainer ring provided for locking a periphery of the wafer while making contact with the polishing pad during polishing the wafer; and a polishing step for polishing the wafer with the polishing pad by a relative motion between the wafer holding head and the platen, characterized in that a slurry holding ring is provided so as to contact the polishing pad and not to contact an outer circumference of the wafer holding head, and is disposed at an outside of the wafer holding head; a slurry is fed by a slurry feed member between the outer circumference of the wafer holding head and the slurry holding ring while allowing the wafer holding head to rotate with respect to the slurry holding ring; and the wafer is polished while preventing the slurry from flowing out by the slurry holding ring.

### BRIEF DESCRIPTION OF THE DRAWINGS

For a better understanding of the present invention, and to show how the same may be carried into effect, reference will now be made, by way of example only, to the accompanying drawings, in which:-
FIG. 1 shows a plan view of a wafer polishing apparatus of a first embodiment useful for understanding the present invention;
FIG. 2 shows a side cross section of the wafer polishing apparatus shown in FIG. 1;
FIG. 3 is a cross section for describing the wafer holding head to be used in the first embodiment;
FIG. 4 shows a cross section showing a second embodiment of a wafer polishing apparatus, which is in accordance with one or more aspects of the present invention;
FIG. 5 shows a cross section showing a third embodiment of a wafer polishing apparatus, which is in accordance with one or more aspects of the present invention;
FIG. 6 shows an overall drawing of the wafer polishing apparatus of the second and third embodiments;
FIG. 7 is an illustrative drawing of the disposition of the wafer holding head in the wafer polishing apparatus in the second and third embodiments;
FIG. 8 shows a plan view viewed from upward of the wafer polishing apparatus in a fourth embodiment which is in accordance with one or more aspects of the present invention.
FIG. 9 shows a side view of the wafer polishing apparatus in FIG. 8;
FIG. 10 shows a cross section of the spindle of the wafer polishing apparatus in a fifth embodiment, useful for understanding of the present invention;
FIG. 11 shows a cross section of the wafer holding head of the wafer polishing apparatus in the fifth embodiment, useful for understanding of the present invention;
FIG. 12 shows the overall wafer polishing apparatus in one example of the fifth embodiment;
FIG. 13 shows a plan view of the wafer transfer apparatus and the wafer polishing apparatus in a sixth embodiment, useful for understanding of the present invention;
FIG. 14 shows a side view of the wafer transfer apparatus and wafer polishing apparatus shown in FIG. 13;
FIG. 15 shows an enlarged drawing in the vicinity of the tray of the wafer transfer apparatus and wafer polishing apparatus shown in FIG. 13;
FIG. 16 shows an enlarged drawing in the vicinity of the wafer attaching-detaching mechanism of the wafer transfer apparatus and wafer polishing apparatus shown in FIG. 13;
FIG. 17 shows an illustrative cross section of the wafer holding head of the wafer polishing apparatus in the sixth embodiment, useful for understanding of the present invention;
FIG. 18 illustrates the conventional wafer polishing apparatus;
FIG. 19 illustrates the conventional wafer polishing apparatus;
FIG. 20 illustrates the wafer holding head to be used in the conventional wafer polishing apparatus; and
FIG. 21 illustrates the conventional wafer polishing apparatus that is a wafer polishing apparatus to which the fifth embodiment is applied.

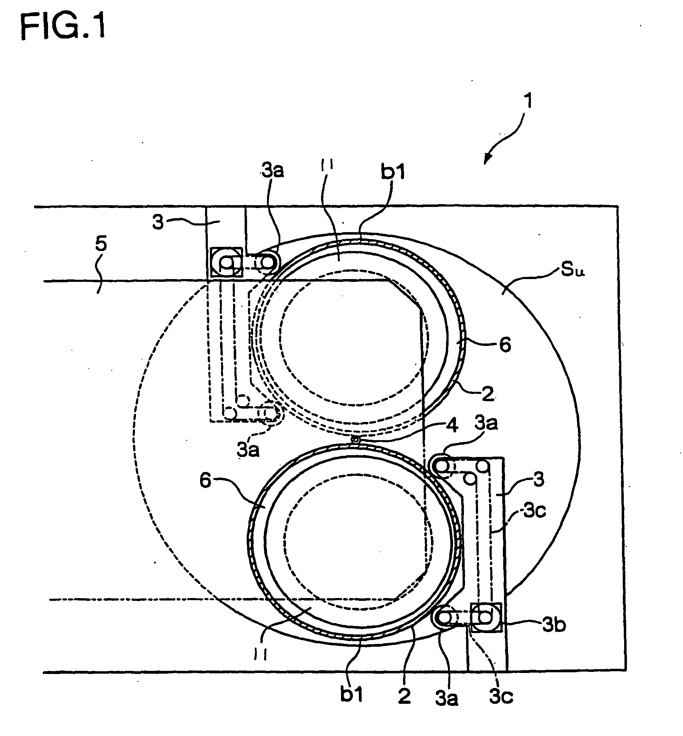

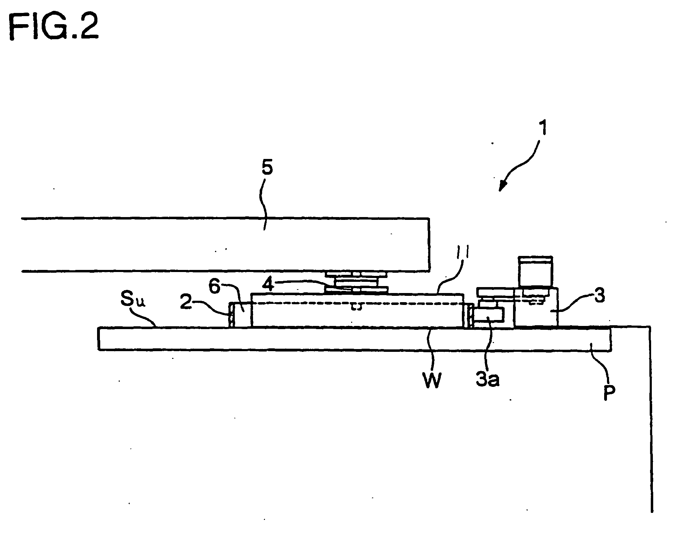

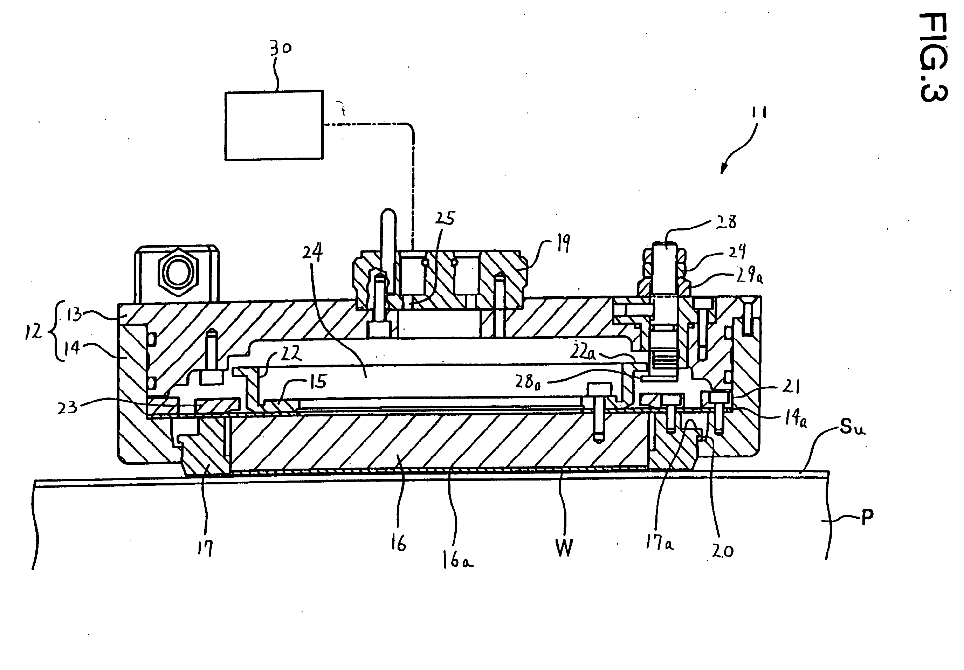

FIG. 1 shows a plan view viewed from upward of the wafer polishing apparatus in the first embodiment not falling within the scope of the claims. FIG. 2 shows a cross section of the wafer polishing apparatus in FIG. 1, and FIG. 3 shows a cross section of one example of the wafer holding head to be used in this embodiment.

In FIGs. 1 and 2, the wafer polishing apparatus 1 is provided with a wafer holding head **11**, a dress ring **2** provided at outside of the wafer holding head **11**, a ring guide **3** supporting the dress ring **2**, and a nozzle **4** as a slurry feed device.

Two wafer holding heads **11** are supported in a freely rotatable manner in this embodiment. A wafer **W** supported with the wafer holding head **11** contact the surface of a polishing pad **Su** affixed on a rotatable platen **P**.

Any materials that have been conventionally used for polishing the wafer may be used for the polishing pad **Su**, examples of them including a velour type pad prepared by impregnating a nonwoven fabric comprising polyester with a soft resin such as polyurethane, a suede type pad prepared by forming a resin foam layer comprising polyurethane foam on a substrate such as a polyester nonwoven fabric, or a resin foam sheet comprising independently foamed polyurethane.

A ring-shaped dress ring **2** having an abrasive grain layer on its lower end face is provided at the outside of the wafer holding head **11**. The dress ring **2** is formed to have a diameter larger than the outer diameter of the wafer holding head **11** and smaller than the radius of the polishing pad **Su**, and is provided to have a gap **6** from the wafer holding head **11**. The abrasive grain layer formed on the lower end face of the dress ring **2** contacts the surface of the polishing pad **Su**.

The dress ring **2** is mounted on the polishing pad **Su**, and is allowed to rotate by the frictional force between the dress ring **2** and the polishing pad **Su** caused by rotation of the platen **P**. Two roller bearings **3a** are provided in respective ring guides **3** supporting the dress rings **2** for maintaining the positions of the dress rings **2** so as not to interfere rotation of the dress rings **2**.

A nozzle (a slurry feed device) **4** for directly feeding a slurry toward the vicinity of the center of the polishing pad **Su** is provided on a base **5**. The nozzle **4** is provided with its tip to be a distance apart from the surface of the polishing pad **Su**, for feeding the slurry at the intermediate part of each dress ring **2**.

The wafer holding head **11** will be then described.

In FIG. 3, the wafer holding head **11** is provided with a head body **12** comprising a top plate **13** and a cylindrical circumference wall **14**, a diaphragm **15** expanded in the head body **12**, a disk-shaped carrier **16** fixed on the lower face of the diaphragm **15**, and a disk-shaped retainer ring **17** provided in a concentric relation to the inner wall of the circumference wall **14** and the outer circumference face of the carrier **16**.

The head body **12** is composed of the disk-shaped top plate **13** and the cylindrical circumference wall **14** fixed at below the outer circumference of the top plate **13**, and the lower end of the head body **12** has an hollow opening. The top plate **13** is coaxially fixed to a shaft **19**, in which a flow path **25** communicating with a pressure adjusting mechanism **30** is formed along the vertical direction. A step **14a** and a locking member **20**, protruding toward the inside along the radial direction, are formed on the lower end of the circumference wall **14** over the entire circumference.

The diaphragm **15** comprising an elastic material such as a fiber reinforced rubber is formed into a ring-shape or a disk-shape, and is fixed with a diaphragm fixing ring **21** on the step **14a** formed on the inner wall of the circumference wall **14**.

A fluid chamber **24** is formed at above the diaphragm **15**, and communicates with the flow path **25** formed in the shaft **19**. The pressure in the fluid chamber **24** is adjusted by feeding a fluid such as air from the pressure adjusting mechanism 30 through the flow path **25**.

The carrier **16** comprising a highly rigid material such as a ceramic is formed into a disk with an approximately constant thickness, and is fixed with a carrier fixing ring **22** provided on the upper face of the diaphragm **15**. A ring-shaped step **22a** is formed on the upper part of the carrier fixing ring **22**, and the step is engaged with a step **28a** formed at the lower end of stopper bolts **28**, which vertically penetrate through the top plate **13**, and are fixed with nuts **29** and spacers **29a**. Consequently, the diaphragm **15** does not suffer an excess force by allowing the step **22a** to engage with the step **28a**, even when the diaphragm **15** is bent downward by the weight of the carrier **16** by allowing the wafer holding head, for example, to ascend.

The retainer ring **17** is formed into a ring shape between the inner wall of the circumference wall **14** and the outer circumference face of the carrier **16**, and is disposed in a concentric relation to the circumference wall **14** and the carrier **16** with a slight gap between the inner wall of the circumference wall **14** and the outer circumference face of the carrier **16**. The retainer ring **17** is fixed with a retainer ring fixing ring **23** provided on the upper face of the diaphragm **15**. The upper end face and the lower end face of the retainer ring **17** is formed to be horizontal. A step **17a** is formed on the outer circumference face of the retainer ring **17**, which prevents the retainer ring **17** from being excessively displaced by allowing the step **17a** to engage with the locking member **20** when the wafer holding head **11** ascends, thereby the diaphragm **15** does not suffer a local force.

A variety of the wafer holding head **11**, such as those in which the wafer holding head is supported with the carousel as a head driving mechanism so as to be able to freely inclined may be used.

The wafer **W** is at first held on the lower face of the wafer holding head **11**, when the wafer **W** is polished with the wafer polishing apparatus **1**. Or, the wafer **W** is at first affixed on the wafer affixing sheet **16a** (an insert) provided at the lower face of the carrier **16**. Then, the surface of the wafer **W** is allowed to contact the polishing pad **Su** affixed on the upper face of the platen **P**, while the periphery of the wafer **W** is locked with the retainer ring **17**.

Subsequently, the pressure in the fluid chamber **24** is adjusted by allowing a fluid such as air to flow in the fluid chamber **24** from the flow path **25**, to adjust the pressing pressure of the carrier **16** and the retainer ring **17** onto the polishing pad **Su**. Since the carrier **16** and the retainer ring **17** has a floating structure being able to independently displace along the ascending and descending directions, respectively, the pressing pressure onto the polishing pad **Su** is adjustable by the pressure in the fluid chamber **24**.

The platen rotates to rotate respective wafer holding heads **11**, while adjusting the pressing pressure of the carrier **16** and the retainer ring **17** onto the polishing pad **Su**. At the same time, the platen **P** on which the polishing pad **Su** is affixed is allowed to rotate along the counter-clockwise direction as shown in FIG. 1 to feed the slurry from the nozzle **4**.

Since the dress ring **2** is mounted on the polishing pad **Su**, it is allowed to rotate by the frictional force between the polishing pad **Su** and the lower face of the dress ring **2**. In other words, while the center side portion and the outer side portion of the polishing pad **Su** suffer different forces acting on the dress ring **2**, the polishing pad **Su** is allowed to rotate by taking advantage of the difference between these forces. For example, when the polishing pad **Su** is allowed to rotate along the counter-clockwise direction as shown in FIG. 1, the position **b1** corresponding to the outer side portion of the polishing pad **Su** suffers the largest frictional force acting on the dress ring **2**. Since the dress ring **2** is supported to be freely rotatable while maintaining its relative position with the ring guide **3**, a force along the counter-clockwise direction also acts on the dress ring **2**. Consequently, the dress ring rotates together with the rotation of the polishing pad **Su,** thereby the former rotates along the counter-clockwise direction.

A driving member **3b** comprising the roller bearings **3a** and a motor may be coupled with a timing belt **3c** to allow the dress ring to actively rotate. An auxiliary force is applied to the dress ring **2** by making the roller bearings **3a** rotatable, thereby making rotation of the dress ring **2** to be smooth. Rotation of a plurality of the roller bearings **3a** is securely synchronized, by allowing respective roller bearings **3a** to drive with one driving member **3b**.

Of course, it is possible to actively rotate the dress ring **2** with the driving member **3b**. For example, the dress ring **2** is allowed to rotate by providing a gear at the outer circumference of the dress ring **2**, as well as a gear at the roller bearing **3a**, and by being engaged with the gears.

The surface of the polishing pad **Su** is then dressed under the action of the abrasive grain layer formed at the lower end face of the dress ring **2**, due to each dress ring **2** rotating.

Polishing of the wafer **W** and dressing of the polishing pad **Su** is simultaneously carried out with good efficiency, by providing the dress rings **2** at the individual outside of the plural wafer holding heads **11** as described above.

Since the wafer holding head is disposed in the cylindrical dress ring **2**, the space inside of the dress ring **2** is effectively utilized. Consequently, a plurality of the wafer holding heads **11** and the dress rings **2** can be disposed on the polishing pad **Su** to improve the service efficiency of the overall apparatus.

The polishing pad **Su** is dressed along with correction of the shape (truing) by disposing a plurality of the dress rings **22** provided with the ring-shaped abrasive grain layer. Although the surface of the polishing pad **Su** becomes a little rough when the thickness of the polishing pad **Su** itself is irregular, or when the thickness of the adhesive layer for affixing the polishing pad **Su** on the platen **P** is not uniform, the shape is corrected to planarize the surface of the polishing pad **Su** by using the dress ring **2**.

Since the dress ring **2** is mounted on the polishing pad **Su**, the pressing force on the polishing pad S**u** is caused by the weight of the dress ring **2**. The dress ring **2** rotates by taking advantage of friction between the dress ring and the polishing pad **Su,** not relying on active means using, for example, various kinds of actuators. Therefore, the contact angle between the dress ring **2** and the polishing pad **Su** is made to be not so inclined, besides the polishing pad **Su** is not forcibly polished. Consequently, the polishing pad **Su** is uniformly dressed without excessively polishing the surface of the polishing pad **Su.**

It is also possible to provide a plurality of nozzles for feeding the slurry to the gaps at the peripheries of each wafer holding head **11**. Since the slurry is maintained by the dress ring **2**, while the polishing pad **Su** is rotating, by feeding the slurry to the gap **6,** the slurry never flows out to the outside along the radial direction due to centrifugal force. Accordingly, consumption of the slurry can be reduced. In addition, since the slurry is directly fed to the periphery of the wafer **W** to be polished, polishing of the wafer **W** and dressing of the polishing pad **Su** are effected with a low cost.

It is also possible to provide a through-hole at a part of the circumference wall of the dress ring **2**. The fresh abrasive fed from the nozzle **4** replaces the denatured abrasive, or the slurry containing polishing debris in a given proportion, since the through-hole formed serves as an output for the slurry accommodated in the gap **6**, enabling degradation of the slurry to be prevented.

### [Second Embodiment]

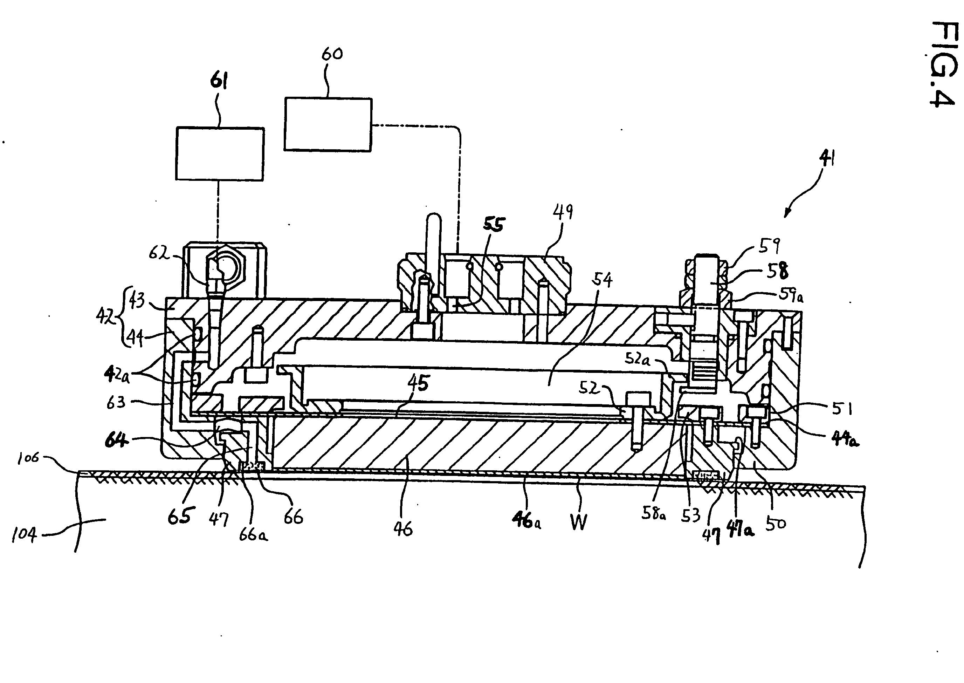

The second embodiment of the wafer polishing apparatus 101, which forms part of the present invention, will be described hereinafter with reference to the drawings. FIG. 4 shows a cross section of a wafer holding head 41 of the wafer polishing apparatus in the second embodiment of the present invention.

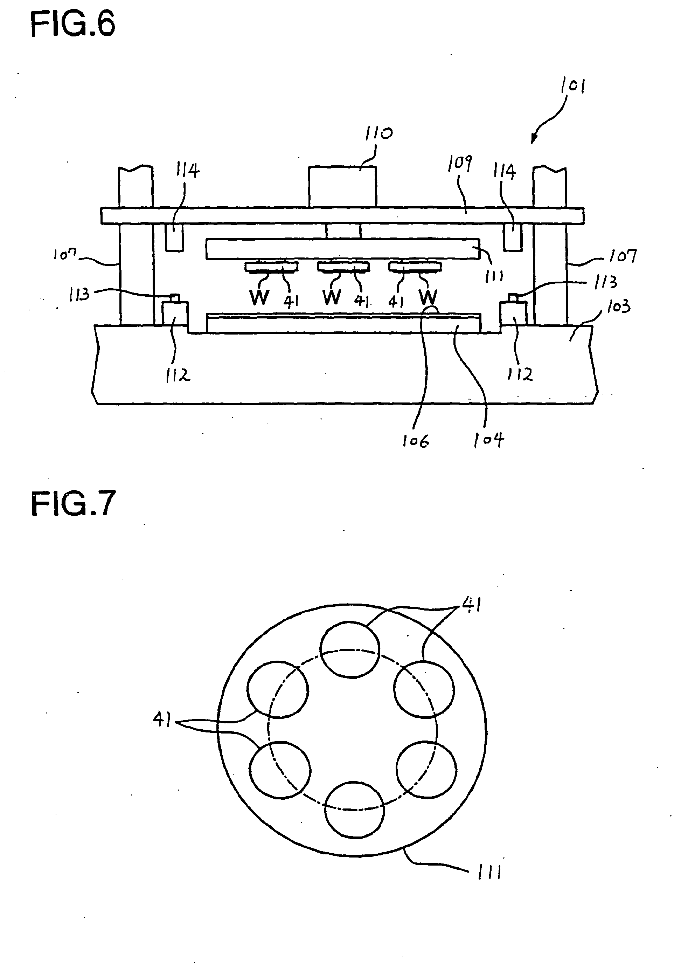

A plurality of the wafer holding heads **41** are mounted on a carousel **111** as a head driving mechanism in the overall wafer polishing apparatus shown, for example, in FIGs. 6 and 7. The wafer holding mechanism undergoes a planetary motion on the polishing pad **106** affixed on the entire surface of the upper face of the platen **104** formed into a disk shape.

In FIG. 6, the platen **104** is horizontally disposed at the center of a base **103**, is allowed to rotate around the axis line with a platen driving mechanism provided in the base **103**. Any materials that have been conventionally used for polishing the wafer may be used for the polishing pad **106** affixed on the surface of the platen **104**, examples of them including a velour type pad prepared by impregnating a nonwoven fabric comprising polyester with a soft resin such as polyurethane, a suede type pad prepared by forming a resin foam layer comprising polyurethane foam on a substrate such as a polyester nonwoven fabric, or a resin foam sheet comprising independently foamed polyurethane.

Guide posts **107** are provided at the side of the base **103**, and an upper mounting plate (bridge) **109** is disposed on the guide posts. The upper mounting plate (bridge) **109** supports a carousel driving mechanism **110**, and a carousel **111** is provided at below the carousel driving mechanism **110**. The carousel driving mechanism **110** serves for rotating the carousel **111** round the axis line.

Bridge supports **112** are disposed so as to protrude upward from the base **103**. A gap adjustment mechanism **113** is provided on the upper end of the bridge support **112**. A locking member **114** is disposed in an opposite relation to the bridge support **112** above the bridge support **112**. The locking member **114** is fixed to the upper mounting plate (bridge) **109**, and protrudes downward from the upper mounting plate (bridge) **109**. The distance between the wafer holding head 41 holding the wafer **W** and the polishing pad **106** is appropriately adjusted by adjusting the gap adjustment mechanism **113** and by allowing the bridge support **112** to contact the locking member **114**.

In total six wafer holding heads **41** in an opposed relation to the platen **104** are provided on the lower face of the carousel **111** The wafer holding heads **41** are disposed at every 600 around the center axis of the carousel **111** with an equal distance apart from the center of the carousel **111** as shown in FIG. 7. Each wafer holding head **41** is allowed to rotate with a head driving mechanism (not shown) along the circumference direction, besides undergoing a planetary motion with the carousel driving mechanism **110**. The center of the platen **104** and the center of revolution of the wafer holding head **41** may be eccentric with each other.

The wafer holding head **41** will be described hereinafter.

As shown in FIG. 4, the wafer holding head **41** is provided with a head body **42** comprising a top plate **43** and a cylindrical circumference wall, a diaphragm **45** expanded in the head body **42**, a disk-shaped carrier **46** fixed on the lower face of the diaphragm **45**, and a ring-shaped retainer ring **47** provided in a concentric relation to the inner face of the circumference wall **44** and the circumference face of the carrier **46**.

The head body **42** is composed of the disk-shaped top plate **43** and the cylindrical circumference wall **44** fixed at below the outer circumference of the top plate **43**, and the lower end of the head body **42** has an hollow opening. The top plate **43** is coaxially fixed to a shaft **49**, in which a flow path **55** communicating with a pressure adjusting mechanism **60** is formed along the vertical direction. A step **44a** and a locking member **50**, protruding toward the inside along the radial direction, are formed on the lower end of the circumference wall **44** over the entire circumference.

The diaphragm **45** comprising an elastic material such as a fiber reinforced rubber is formed into a ring-shape or a disk-shape, and is fixed with a diaphragm fixing ring **51** on the step **44a** formed on the inner wall of the circumference wall **44**.

A fluid chamber **54** is formed at the upward of the diaphragm **45**, and communicates with the flow path **55** formed in the shaft **49**. The pressure in the fluid chamber **54** is adjusted by feeding a fluid such as air from the pressure adjusting mechanism **60** through the flow path **55**.

The carrier **46** comprising a highly rigid material such as a ceramic is formed into a disk with an approximately constant thickness, and is fixed with a carrier fixing ring **52** provided on the upper face of the diaphragm **45**. A ring-shaped step **52a** is formed on the upper part of the carrier fixing ring **52**, and the step engages with a step **58a** formed at the lower end of stopper bolts **58**, which vertically penetrate through the top plate **43**, and are fixed with nuts **59** and spacers **59a**. Consequently, the diaphragm **45** does not suffer an excess force by allowing the step **52a** to engage with the step **58a**, even when the diaphragm **45** is bent downward by the weight of the carrier **46** by allowing the wafer holding head to ascend.

The retainer ring **47** is formed into a ring shape between the inner wall of the circumference wall **44** and the outer circumference face of the carrier **46**, and is disposed in a concentric relation to the circumference wall **44** and the carrier **46** with a slight gap between the inner wall of the circumference wall **44** and the outer circumference face of the carrier **46**. The retainer ring **47** is fixed with a retainer ring fixing ring **53** provided on the upper face of the diaphragm **45**. The upper end face and the lower end face of the retainer ring **47** is formed to be horizontal. A step **47a** is formed on the outer circumference face of the retainer ring **47**, which prevents the retainer ring **47** from being excessively displaced by allowing the step **47a** to engage with the locking member **50** when the wafer holding head **41** ascends, thereby the diaphragm **45** does not suffer a local force.

A joint **62** for coupling with a slurry feed member **61** is provided at the top plate **43** of the head body **42**. A head body tube **63,** which is formed along the vertical direction in the top plate **43** and communicate with the circumference wall **44**, is formed from the joint **62**. An O-ring **42a** is provided between the top plate **43** and the circumference wall **44** to allow the top plate **43** to securely contact the circumference wall **44**.

The lower end of the head body tube **63** is formed so as to penetrate toward the inner circumference side of the circumference wall **44**, and coupled with one end of a flexible tube **64**. The flexible tube **64** is made of an elastic material such as a rubber tube, and the end of the tube communicates with a retainer ring tube **65** formed in the retainer ring **47**.

The retainer ring **65** is provided so that the tube penetrates through the outer circumference and lower face of the retainer ring, and a slurry pocket **66** is formed at the lower end side. The slurry pocket **66** communicates with the retainer ring tube **65**, and is formed into a ring-shaped groove that crawls along the lower face of the retainer ring and is open at the polishing pad **106** side. The slurry fed from the slurry feed member **61** flows into the slurry pocket **66** through the head body tube **63**, flexible tube **64** and retainer ring tube **65**.

When the wafer **W** is polished using the wafer holding head **41** as described above, the wafer **W** is at first affixed on a wafer affixing sheet **46a** (an insert). Then, the surface of the wafer **W** is allowed to contact the polishing pad **106** affixed on the upper face of the platen **104**, while the periphery of the wafer **W** is locked with the retainer ring **47**. The lower face of the retainer ring **47** provided with the slurry pocket **66** is also allowed to contact the polishing pad **106**.

Subsequently, the pressure in the fluid chamber **54** is adjusted by allowing a fluid such as air to flow in the fluid chamber **54** from the flow path **55**, to adjust the pressing pressure of the carrier **46** and the retainer ring **47** onto the polishing pad **106**. Since the carrier **46** and the retainer ring **47** has a floating structure being able to independently displace along the ascending and descending directions by being supported with the diaphragm **45**, the pressing pressure onto the polishing pad 106 is adjustable by the pressure in the fluid chamber **54**.

The platen **104** is allowed to rotate while allowing the wafer holding head **41** to undergo a planetary motion, by adjusting the pressing pressure of the carrier **46** and the retainer ring **47** onto the polishing pad **106**.

During the process described above, the slurry is fed from the slurry feed member **61** to the head body tube **63**. The slurry flows into the slurry pocket **66** through the head body tube **63**, flexible tube **64**, and retainer ring tube **65**. Since the opening side of the slurry pocket **66** is blocked with the polishing pad **106**, the slurry is equally distributed along the ring-shaped groove of the slurry pocket **66**.

The slurry is fed from the slurry pocket **66** onto the surface of the polishing pad **106,** by allowing the wafer holding head **41** to rotate. The surface of the wafer **W** is polished after the slurry has been fed onto the polishing face of the wafer **W**.

The polishing face of the wafer **W** is efficiently polished, since the slurry is directly fed from the slurry pocket **66** formed around the wafer **W**. The slurry pocket **66** is formed into a ring-shaped groove on the lower face of the retainer ring **47** making contact with the surface of the polishing pad **106**. Accordingly, the slurry never flows out along the radial direction even when the polishing pad **106** affixed on the platen **104**, and the wafer holding head **41** itself rotate, because the slurry is held in the slurry pocket **66**, thereby making it possible to efficiently polish the wafer with a minimum consumption of the slurry. Since the wafer holding head **41** itself is rotating, the slurry can be evenly fed onto the surface of the polishing pad **106**, allowing the slurry to exhibit an efficient polishing function.

While some of the polishing debris generated by polishing is stirred with the slurry in the slurry pocket **66** by rotation of the wafer holding head **41** and the polishing pad **106**, the polishing debris affixed on the polishing pad **106** is efficiently removed with, for example, pH controlled water supplied at around the center of the polishing pad **106**.

It is also possible to remove the polishing debris using only water the pH of which has not been controlled, or a diluted abrasive, to reduce consumption of expensive abrasive.

The slurry is fed without inhibiting displacement of the retainer ring along the axis line direction, thus allowing secure polishing, by communicating the head body tube **63** with the retainer ring **65** using the flexible tube **64** comprising an elastic material.

While the slurry pocket **66** in this embodiment is provided so that its upper face **66a** lies parallel to the lower face of the retainer ring **47** as shown in FIG. 4, a step may be provided between the carrier **46** side and the circumference wall **44** side. For example, lowering the carrier **46** side of the upper face **66a** is effective for feeding a larger amount of the slurry to the wafer **W** side, because the slurry in the slurry pocket **66** tends to easily flow into the wafer **W** side. Lowering the circumference wall **44** side of the upper face **66a** is effective, on the other hand, for preferentially removing the polishing debris, because the slurry tends to easily flow out.

### [Third Embodiment]

The wafer holding head 71 according to the third embodiment, which forms part of the present invention, will be described hereinafter with reference to the drawings.

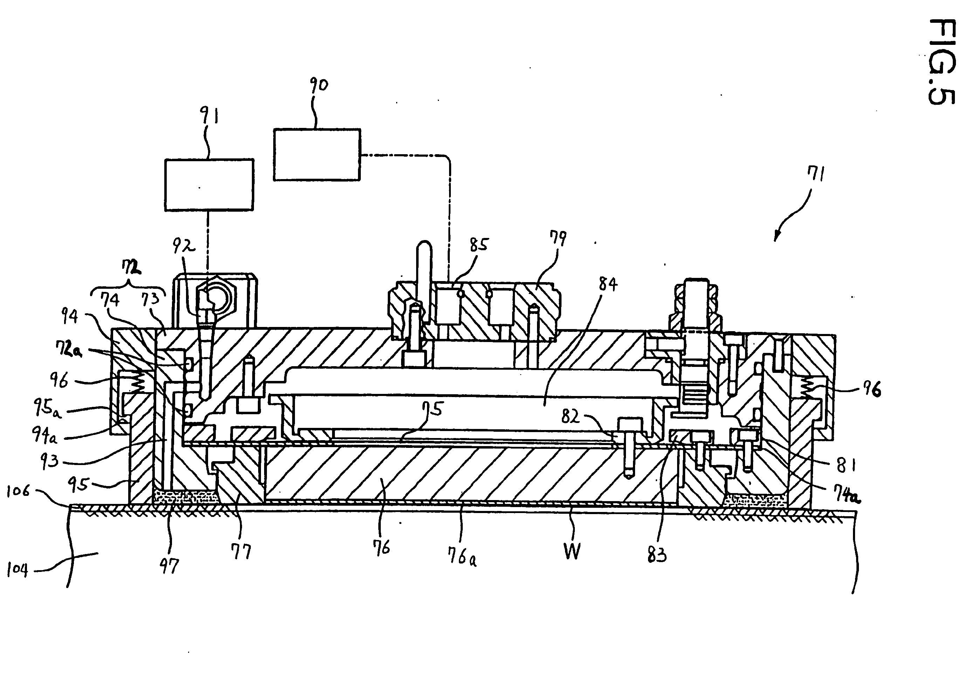

A plurality of the wafer holding heads **71** shown in FIG. 5 in the overall drawing of the wafer polishing apparatus **101** in, for example, FIG. 6 are provided under the carousel **111** as a head driving mechanism, and they undergo a planetary motion on the polishing pad **106** affixed on the platen **104**.

In FIG. 5, the wafer holding head **71** is provided with a head body **72** comprising a top plate **73** and a cylindrical circumference wall **74**, a diaphragm **75** comprising an elastic material such as a fiber reinforced rubber expanded in the head body **72,** a carrier **76** fixed at the lower face of the diaphragm **75,** and a ring-shaped retainer ring **77** provided in a concentric relation to the inner wall of the circumference wall **74** and the circumference face of the carrier **76.**

A flow path **85** communicating with the pressure adjustment mechanism **90**, which also communicates with a fluid chamber **84**, is formed along the vertical direction in the shaft **79** for coupling to the carousel **111**. The diaphragm **75** is fixed to a step **74a** formed at the lower end of the circumference wall **74** with a diaphragm fixing ring **81**.

The disk-shaped carrier **76** is fixed with a carrier fixing ring **82** via the diaphragm **75**, and the ring-shaped retainer ring **77** is fixed with a retainer ring fixing ring **83**.

A head body tube **93** communicates with a joint **92** coupled to a slurry feed member **91**. The head body tube **93** is vertically formed toward downward through the top plate **73** to a midway height, extends toward the circumference wall **74**, and finally penetrates through an approximately mid point of the circumference wall **74** toward the lower face of the circumference wall **74**. The top plate **73** and the circumference wall **74** are coupled via an O-ring **72a**.

A ring-shaped outer ring supporting member **94** is provided at the outside of the head body **72**. The upper part of the outer ring supporting member **94** is fixed to the side wall of the top plate **73**, and the lower part of the outer ring supporting member **94**, positioned at a mid-height at the outside of the circumference wall **74**, is formed to have a L-shaped cross section bent toward the inside to form a step **94a**.

A ring-shaped outer ring **95** is provided in the inner space of the outer ring supporting member **94**. The outer ring **95** is coupled to the inner space of the outer ring supporting member **94** with an outer ring press member **96** comprising an elastic material such as a spring, and is supported to be able to displace along the ascending and descending direction.

A step **95a** protruding to the outside is formed at the upper part of the outer ring **95**. The step **94a** of the outer ring supporting member **94** serves for enhancing the wafer holding head **71** to move downward, when it ascends by means of an ascending-descending mechanism.

The lower face of the outer ring **95** contacts the surface of the polishing pad **106**, in order to form a slurry pocket **97** utilizing the inner circumference face of the outer ring **95**, the outer circumference face of the retainer ring **77**, and the lower face of the circumference wall.

When the wafer **W** is polished using the wafer holding head **71** constructed as described above, the wafer **W** is affixed on a wafer affixing sheet **76a** (an insert) provided on the lower face of the carrier **76** and is locked with the retainer ring **77**. Then, the surface of the wafer **W** is allowed to contact the polishing pad **106** affixed on the upper face of the platen **104**. The pressing force of the carrier **76** and the retainer ring **77** onto the polishing pad **106** is adjusted by adjusting the pressure in the fluid chamber **84**.

The platen **104** is allowed to rotate while the wafer holding head **71** is allowed to undergo a planetary motion. The slurry flows through the head body tube **93** from the slurry feed member **91** to feed it in the slurry pocket **97**.

Since the retainer ring **77** and the outer ring **95** have a floating structure by which they are able to displace along the axis direction, their lower faces can securely come in contact with the polishing pad **106**.

The slurry is fed onto the surface of the polishing pad **106** from the slurry pocket **97**, by allowing the wafer holding head **71** to rotate to polish the wafer **W**. The slurry is efficiently fed onto the polishing face of the wafer **W**, since the slurry is directly fed from the slurry pocket **97** formed in the periphery of the wafer **W**.

The slurry pocket **97** is surrounded by the outer ring 95, the retainer ring **77** and the circumference wall **74**, and the retainer ring **77** and the outer ring **95** have a floating structure, respectively, by which the retainer ring **77** and the outer ring **95** are able to displace along the ascending and descending directions by means of the diaphragm **75** and the outer ring press member **96**. Accordingly, the lower faces of them securely contact the polishing pad **106**. Consequently, the slurry does not flow out in a large amount due to centrifugal force even when the wafer holding head **71** itself rotates, since the slurry is retained in the slurry pocket **97**. The slurry is evenly fed onto the surface of the polishing pad **106** by rotation of the wafer holding head **71**, allowing the slurry to efficiently exhibit polishing effect.

The polishing debris generated by polishing is mixed with there abrasive in the slurry pocket **97** that is stirred by rotation of the wafer holding head **71**, thus allowing the polishing debris to be efficiently removed from the surface of the polishing pad **106**. Although the polishing debris has been flowed out using a large amount of the slurry in the related art, it is removable by using the slurry, or a solution of the slurry, or a diluted abrasive in the present invention, thereby making it possible to save consumption of the expensive abrasive.

It is naturally possible to provide the slurry pocket on the lower face of the retainer ring **77** of the wafer holding head **71**. The construction described above allows the slurry to be fed into the slurry pocket formed on the lower face of the retainer ring **77**, and into the slurry pocket **97**, formed between the retainer ring **77** and the outer ring **95** by providing the outer ring **95** at the outside of the head body **72**, to reduce the amount of the flowing out abrasive, thereby saving the amount of the waste abrasive.

### [Fourth embodiment]

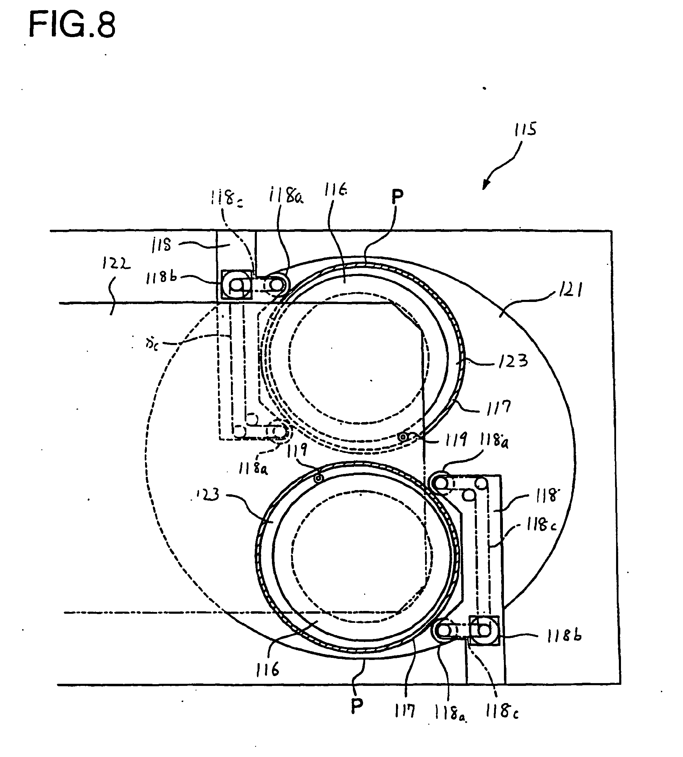

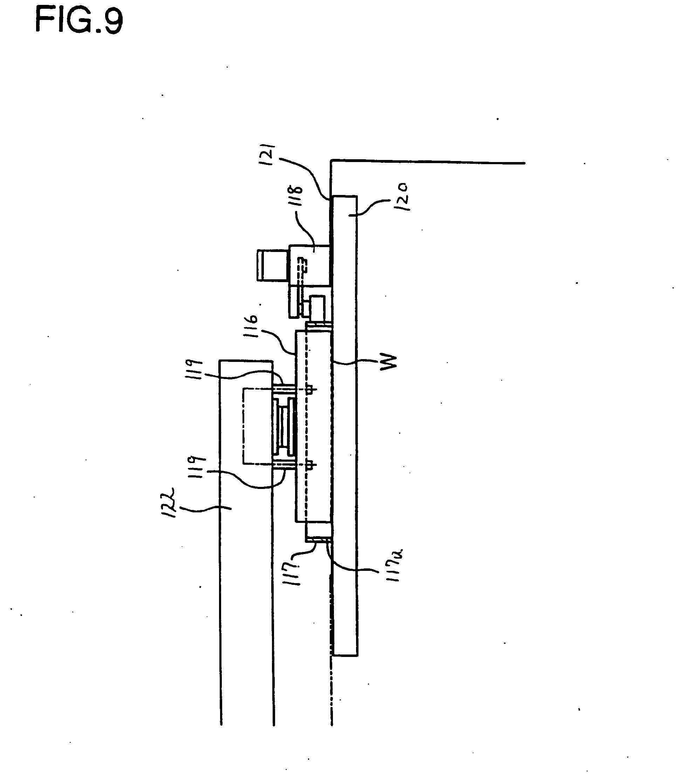

The wafer polishing apparatus according to the fourth embodiment, which forms part of the present invention, will be described hereinafter with reference to FIGs. 8 and 9.

In FIGs. 8 and 9, the wafer polishing apparatus **115** is provided with a wafer holding head **116**, a slurry holding ring **117** provided at the outside of the wafer holding head **116**, a ring guide **118** for supporting the slurry holding ring **117**, and a slurry feed member **119**. The wafer holding head **116** as shown, for example, in FIG. 20 may be used.

The wafer holding heads **116**, two in this embodiment, are supported on the base **122** in a freely rotatable manner. The wafer **W** supported with the wafer holding heads **116** makes contact with the surface of a polishing pad **121** affixed on a rotating platen **120**.

The ring-shaped slurry holding ring **117** provided at outside of the wafer holding heads **116** is formed to have a diameter larger than the outer diameter of the wafer holding heads **116** and smaller than the radius of the polishing pad **121** with a gap **123** from the wafer holding heads **116**. The lower end face of the slurry holding ring **117** makes contact with the surface of the polishing pad **121**.

The slurry holding ring **117** is mounted on the polishing pad **121**, and is allowed to rotate by the frictional force between the polishing pad **121** and the slurry holding ring **117** generated by rotation of the platen **120**. The ring guide **118** supporting the slurry holding ring **117** is provided with two roller bearings **118a**, which support the slurry holding ring **117** so as not to inhibit rotation of the slurry holding ring **117**.

A slurry feed member **119**, for feeding the slurry to the gap **123** formed between the slurry holding ring **117** and the wafer holding head **116**, is provided on the base **122**.

The tubular feed member **119** is disposed at two sites for feeding the abrasive slurry to respective gaps **123** with its tip in a space apart from the polishing pad **121**.

An outlet **117a** as a penetration hole is formed at the lower part of the side wall of the retainer holding ring **117**, for replacing the slurry accommodated in the gap **123** with the fresh abrasive fed from the slurry feed member **119**. The outlet **117a** is formed at a little above the lower end of the slurry holding ring **117**, and is allowed to contact the polishing pad **121** while maintaining a ring-shape of the abrasive grain layer provided at the lower end of the slurry holding ring **117**.

When the wafer **W** is polished with the wafer polishing apparatus **115** as hitherto described, the wafer **W** is at first held on the lower face of the wafer holding head **116**. The polishing face of the wafer **W** is allowed to contact the polishing pad **121** while the wafer holding head **116** is rotating. The platen **120** on which the polishing pad **121** is affixed is allowed to rotate along the counter-clockwise direction as shown in FIG. 8 to feed the slurry into the gap **123** from the slurry feed member **119**.

The slurry holding ring **117** is mounted on the polishing pad **121**, and is allowed to rotate by frictional force between the rotating polishing pad **121** and the slurry holding ring **117**. In other words, since the forces acting on the slurry holding ring **117** are different between the portions at around the center and at the outside of the polishing pad **121**, the slurry holding ring **117** is allowed to rotate by taking advantage of the difference between the two forces described above. For example, when the polishing pad **121** is allowed to rotate along the counter-clockwise direction as shown in FIG. 8, the portion having the largest frictional force acting on the slurry holding ring **117** corresponds to the position **P** at the outside of the polishing pad **121**. Since the slurry holding ring **117** is supported by the ring guide **118** in a rotatable manner while maintaining its relative position, a force along the counter-clockwise direction also acts on the slurry holding ring **117**. Consequently, the slurry holding ring **117** is allowed to rotate along the counter-clockwise direction so as to be engaged with rotation of the polishing pad **121**.

Respective roller bearings **118a** may be coupled with a driving mechanism **118b** with a timing belt **118c** for allowing the slurry holding ring to actively rotate. The slurry holding ring **117** smoothly rotates by receiving an auxiliary force by making the roller bearings **118a** to be rotatable. Synchronized rotation of a plurality of the roller bearings **118a** is secured by allowing respective roller bearings **118a** to drive using one driving mechanism **118b.**

The slurry fed into the gap **123** is prevented from flowing out by means of the slurry holding ring **117**. The wafer **W** is polished while being fed with the slurry, by allowing the wafer holding head **116** provided in the slurry holding ring **117** to rotate. The slurry holding ring **117** does not change the relative position between the polishing pad **121** and the wafer holding head **116**, since the slurry holding ring **117** simultaneously rotates, thereby the slurry in the gap is securely maintained.

The slurry is efficiently fed from around the wafer holding head **116**, by providing the slurry holding ring **117** at the outside of the wafer holding head **116** to feed the slurry into the gap **123** formed between the wafer holding head **116** and the slurry holding ring **117**. Since the slurry is prevented from flowing out by the slurry holding ring **117** even when the polishing pad **121** is rotating, consumption of the slurry is saved to enable the wafer **W** to be efficiently polished with a low cost.

The polishing debris generated by polishing is removed by being mixed with the slurry accommodated in the gap **123**. The polishing debris can be removed by merely feeding the soluble portion of the slurry from the slurry feed member **119** to save the slurry.

The degraded slurry in the gap **123**, or the slurry containing the polishing debris is replaced with the fresh abrasive fed from the slurry feed member **119**, by providing an outlet **117a** in the slurry holding ring **117**, thereby allowing denaturation of the slurry to be prevented.

Since the slurry holding ring **117** is mounted on the polishing pad **121**, a pressing pressure is applied on the polishing pad **121** by the weight of the slurry holding ring **117**. Rotation of slurry holding ring **117** takes advantage of the frictional force between the slurry holding ring **117** and the polishing pad **121**. For example, since the slurry holding ring **117** is allowed to rotate not depending on an active method using a various kinds of actuators, the contact angle between the slurry holding ring **117** and the polishing pad **121** is adjusted not to be so extremely inclined. Therefore, the polishing pad **121** is prevented from suffering a local pressing pressure due to the slurry holding ring **117** to prevent the polishing pad **121** from being damaged.

It is also possible to provide an abrasive grain layer on the lower end face of the slurry holding ring **117,** in order to endow the polishing pad **121** with a dressing function. Polishing of the wafer **W** and dressing of the polishing pad **121** may be simultaneously carried out by allowing the slurry holding ring **117** to have a dressing function, thereby making it possible to shorten the manufacturing process. In addition, the slurry is directly fed from the periphery of the wafer **W** to enable efficient polishing while suppressing the slurry from flowing out, by directly feeding the slurry into the gap **123** between the slurry holding ring **117** and the wafer holding head 116.

Since the slurry holding ring **117** provided with the abrasive grain layer is mounted on the polishing pad **121**, the contact angle to the polishing pad **121** is adjusted so that the angle is not so remarkably inclined, besides preventing the polishing pad **121** from being forcibly polished. Therefore, the surface of the polishing pad **121** is not excessively polished to enable a uniform dressing.

The embodiments as set forth above is not necessarily limited to polishing of the wafer **W**, but may be applied to a variety of polishing objects such as a hard disk substrate that require a mirror polishing finish.

### [Fifth Embodiment]

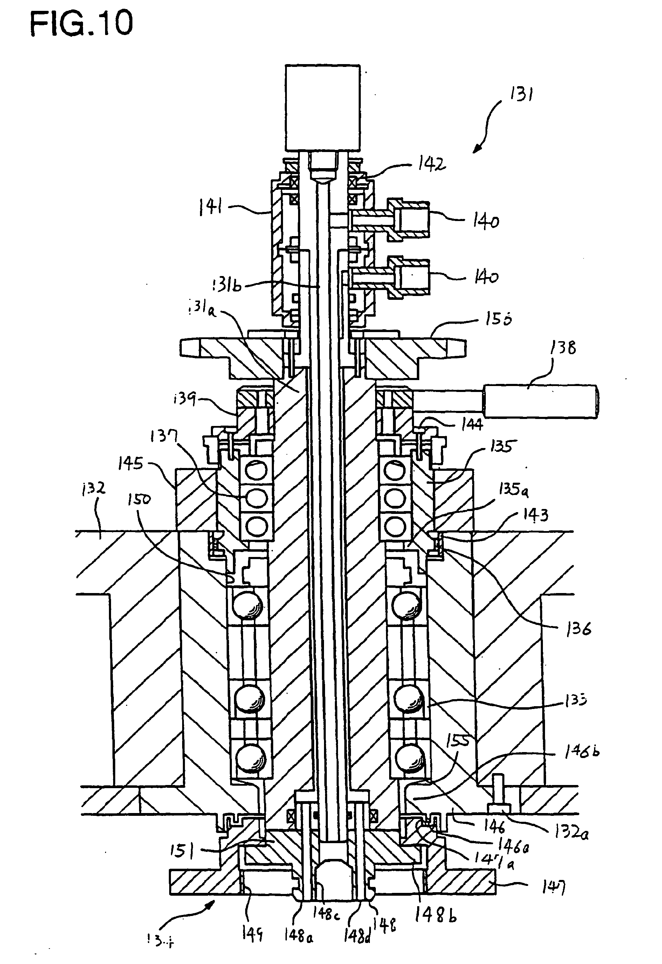

The wafer polishing apparatus and the method for manufacturing the wafer according to a fifth embodiment useful for understanding the present invention but not falling within the scope of the claims will be described hereinafter with reference to the drawings. FIG. 10 shows a cross section of a spindle **131** in the wafer polishing apparatus.

The spindle **131** is provided at the coupling portion between the carousel (spindle supporting member) and the wafer holding head as shown in FIG. 21.

In FIG. 10, the spindle **131** is provided within the engage member **150** as a penetration hole formed in the spindle housing **146** provided through the carousel **132**. The spindle **131** is provided with a main shaft **131a** approximately formed into a cylinder, a spindle side coupling member **134** disposed at the lower part of the carousel **132**, a handle supporting member **139** disposed at the upper part of the carousel **132**, a positioning handle **138** provided so as to extend toward the horizontal direction from the handle supporting member **139**, and fluid feed ports **140** communicating with the tube **131b** of the main shaft **131a** provided at the upper end. A first bearing **133** is provided in the engage member **150**, and the main shaft **131a** is supported with the first bearing **133** to be freely rotatable. A flange **145** is provided on the upper face of the carousel **132**. The spindle **131** is coupled with the carousel **132** by fixing screws **132a**.

The first bearing **133** is fitted into the cylindrical engage member **150** formed in the spindle housing **146**. The first bearing **133** is supported in the engage member **150** so as to be freely slidable, and the outer circumference of the first bearing **133** and the inner circumference of the engage member **150** is not fixed. The first bearing **133** is provided so that the relative position against the main shaft **131a** does not change along the axis line direction.

A ring shape hillock **146a** is formed toward downward along the vertical direction on the lower face of the spindle housing **146**. A disk-shaped locking member **146b** is formed by protruding along the radial direction at the lower part of the inner circumference of the first bearing **133**, and restricts the first bearing **133**, supported to be freely slidable, from moving downward. A ring-shaped leaf spring **155** may be provided on the upper face of the locking member **146b** to relax the impact applied with the leaf spring **155** when the lower part of the first bearing **133** comes in contact with the locking member **146b**.

A bearing supporting member **135** is provided in the upper side flange **145** formed into a cylinder, and a positioning external thread **136** is formed on the outer circumference face of the cylinder. The positioning external thread **136** is screwed into the positioning internal thread **143** formed at the upper part of the inner circumference face of the spindle housing **146**. The width of the positioning internal thread **143** along the axis line direction is formed to be larger than the width of the positioning external thread **136** along the axis line direction. The outer circumference face of the bearing supporting member **135** makes a contact with the inner circumference face of the upper side flange **145**, and the bearing supporting member **135** is rotatable in the upper side flange **145**.

A second bearing **137** is provided in the cylindrical bearing supporting member **135**, and the main shaft **131a** is supported with the second bearing **137** and the first bearing **133** to be freely rotatable. A step **135a** is formed at the lower end of the bearing supporting member **135** so as to support the second bearing **137** from below. The outer circumference of the second bearing **137** is fixed to the inner circumference of the bearing supporting member **135**. The second bearing **137** comprises an angular ball bearing, which restricts movement of the main shaft **131a** along the axis line direction (thrust direction). Accordingly, the relative position between the main shaft **131a** and the second bearing **137** does not change.

A cylindrical handle supporting member **139** is provided at the upward of the bearing supporting member **135**. The handle supporting member **139** is fixed to the bearing supporting member **135** with bolts **144**, and is connected to a positioning handle **138** provided so as to extend along the horizontal direction. The main shaft **131a** is freely rotatable in the cylindrical handle supporting member **139**. The main shaft **131a** is allowed to travel along the axis line direction by allowing the handle supporting member **139** to turn together with the bearing supporting member **135** using the positioning handle **138**.

The bearing supporting member **135**, the handle supporting member **139** and the second bearing **137** are fixed with each other, while the first bearing **133** is slidable against the spindle housing **146**. Shift of the main shaft **131a** along the thrust direction is restricted with second bearing **137**, while the first bearing **133**, the second bearing **137** and the main shaft **131a** are provided so that the relative position among them does not change.

The positioning external thread **136** rotates along the positioning internal thread **143** by turning the bearing supporting member **135**, thereby the bearing supporting member **135** shifts along the axis line direction relative to the spindle housing **146**. Consequently, the main shaft **131a** is allowed to shift along the axis line direction relative to the spindle housing **146** fixed to the carousel **132**, without changing the relative position against the bearing supporting member **135**.

A scale disk **156** is provided at the upper part of the handle supporting member **139**, and the rotation angle of the handle supporting member **139** is confirmed using the scale panel **156**.

Fluid feed ports **140** for communicating into the tube **131b** of the main shaft **131a** is provided at the upper part of the spindle **131**. The fluid such as air fed from the fluid feed port **140** is sent to the opening side at the lower end of the spindle **131** through the tube **131b**. A housing **141** is provided around the main shaft **131a** in the vicinity of the fluid feed port **140**, which prevents the fluid other than the fluid fed from the fluid feed port **140** from invading into the tube **131b**. A third bearing **142** is provided in the housing **141** so as not to disturb rotation of the main shaft **131a**.

A spindle side coupling member **134** for coupling the wafer holding head is provided at the lower part of the spindle **131** protruding toward the downward of the carousel **132**. The spindle side coupling member **134** is provided with an outer cylinder **147** coupled to the main shaft **131a**, and a cylindrical positioning member **148** provided in the outer cylinder **147**. Positioning of the wafer holding head coupled to the spindle side coupling member **134** is adjustable by changing the thickness of a spacer **151** integrated at the upper part of the positioning member **148**.

The positioning member **148** as a centering adapter comprises a cylindrical projection **148a** formed so as to protrude downward, a brim **148b** formed so as to continue to the projection **148a**, and a recess **148c** as a space in the projection **148a**. A feed tube **148d**, formed along the vertical direction so as to communicate with the tube **131b**, is provided in the projection **148a** so as to penetrate to the lower end face of the projection **148a**.

A head attaching internal thread **149** is formed on the inner circumference face of the outer cylinder **147** at a height opposed to the outer circumference face of the projection **148a**. A ring-shaped recess **147a** formed so as to follow the ring-shaped hillock **146a** is also provided on the upper face at the outside of the outer cylinder **147**. A labyrinth ring is formed with these members. Since a viscous frictional resistance and surface tension apply in the gap having a complex configuration formed with the ring-shaped hillock **146a** the ring-shaped recess **147a**, a fluid such as the slurry or foreign substances does not invade in the first bearing **133** side.

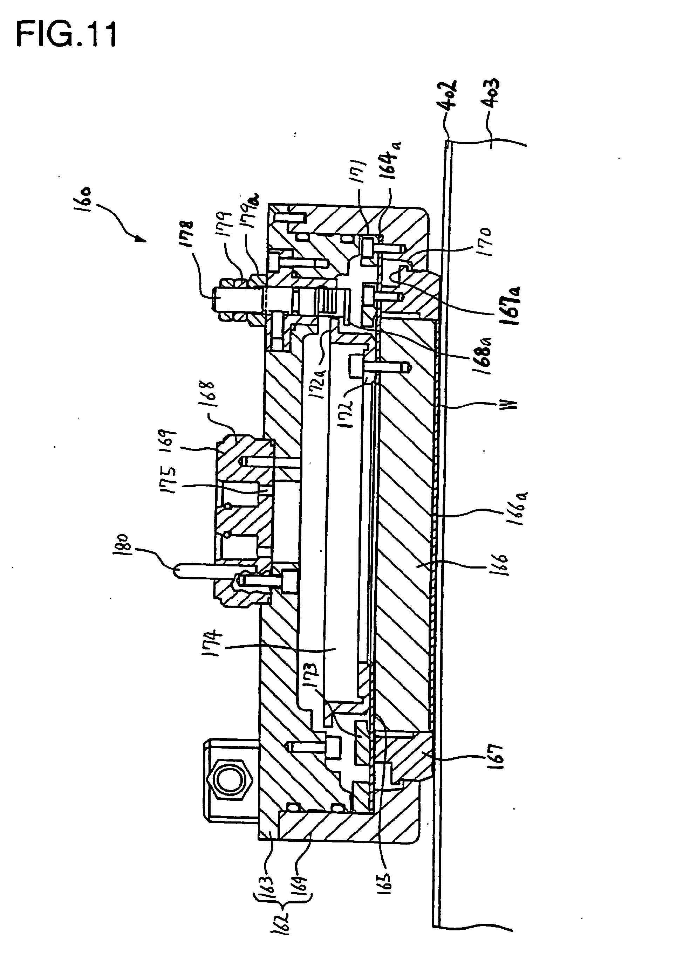

The wafer holding head attached to the spindle **131** will be described hereinafter with reference to FIG. 11.

The wafer holding head in FIG. 11 is provided with a head body **162**, a diaphragm **165** expanded in the head body **162**, a disk-shaped carrier **166** fixed on the lower face of the diaphragm **165**, and a retainer ring **167** provided in a concentric relation to the inner wall of the circumference wall **164** and the outer circumference wall of the carrier **166**. The carrier **166** and the retainer ring **167** have a floating structure movable along the axis direction by elastic deformation of the diaphragm **165**.

The head body **162** is composed of a disk-shaped top plate **163** and a cylindrical circumference wall **164** fixed at below the circumference of the top plate **163**, and the lower end of the head body **162** has a hollow opening. The top plate **163** is fixed in a coaxial relation to a shaft **169** as a head side coupling member for coupling with the spindle **131**. A flow path **175** for communicating with a tube **131b** in the spindle **131** is formed along the vertical direction in the shaft **169.** A head attaching external thread **168** is formed on the outer circumference face of the shaft **169**. A step **164a** and a ring-shaped locking member **170**, protruding toward inside along the radial direction, are formed over the entire circumference at the lower part of the circumference wall **164**.

The diaphragm **165** comprising an elastic material such as a fiber reinforced rubber is formed into a ring shape or a disk shape, and is fixed with a diaphragm fixing ring **171** on the step **164a** formed on the inner wall of the circumference wall **164**.

A fluid chamber **147** is formed above the diaphragm **165**, and communicates with the flow path **175** formed in the shaft **169**. The pressure in the fluid chamber **147** is adjusted by feeding a fluid such as air into the fluid chamber 1**47** from the tube **131b** in the spindle **131** through the flow path **175**.

The carrier **166** comprising a highly rigid material such as a ceramic is approximately formed into a cylinder having a given thickness, and is fixed with a carrier fixing ring **172** provided on the upper face of the diaphragm **165.** A ring-shaped step **172a** is formed at the upper part of the carrier fixing ring **172,** and engages with a step **178a** formed at the lower end of stopper bolts **178** fixed with nuts **179,** penetrating through the top plate **163** along the vertical direction, and a spacer **179a.** Consequently, the diaphragm **165** does not suffer an excess force by allowing the step **172a** to engage with the step **178a**, even when the diaphragm **165** is bent downward by the weight of the carrier **166** by allowing the wafer holding head, for example, to ascend with an ascending-descending mechanism (not shown).

The retainer ring **167** is formed into a ring shape between the inner wall of the circumference wall **164** and the outer circumference face of the carrier **166,** and is disposed in a concentric relation to the inner wall of the circumference wall **164** and the outer circumference face of the carrier **166** with a slight gap from the circumference wall **164** and the outer circumference face of the carrier **166.** The retainer ring **167** has horizontal upper and lower end faces, and are fixed with a retainer fixing ring **173** provided at the upper face of the diaphragm **165.** The step **167a** is formed on the outer circumference face of the retainer ring **167.** The diaphragm **167** is prevented from suffering a local force by suppressing excess downward movement of the retainer ring **167,** by allowing the step **167a** to engage with the locking member **170** when the wafer holding head ascends with the ascending-descending mechanism.

The spindle **131** and the wafer holding head **160** having the construction as described above are coupled with each other by screwing the head attaching internal thread **149** to the head attaching external thread **168** formed on the respective members.

The wafer holding head **160** is disposed at the lower part of the spindle side coupling member **134** of the spindle **131,** followed by allowing the shaft **169** as a head coupling member to come close to the spindle side coupling member **134** by positioning the projection **148a** and the flow path **175** so as to fit with each other. Positioning of the centers of the spindle **131** and the wafer holding head **160** is made easy by providing the positioning member **148** for centering the spindle side coupling member **134** as described above.

The head attaching internal thread **149** is screwed to the head attaching external thread **168** during positioning. Coupling between the wafer holding head **160** and the spindle **131** is completed when the both threads are screwed until the upper end face of the shaft **169** of the wafer holding head **160** comes in contact with the brim **148b** of the positioning member **148** provided in the spindle side coupling member **134.** The torque acting on the spindle **131** is transferred with a pin **180** engaged with the inside of the spindle side coupling member **134.**

When the wafer **W** is polished using the wafer holding head **160** coupled to the spindle **131,** the wafer **W** is at first affixed on the wafer affixing sheet **166a** (an insert) provided on the lower face of the carrier **166.** Then, the wafer **W** is allowed to contact the polishing pad **402** the surface of which is affixed on the upper face of the platen **403,** while the periphery of the wafer **W** is locked with the retainer ring **167.** Any materials that have been conventionally used for polishing the wafer may be used for the polishing pad Su, examples of them including a velour type pad prepared by impregnating a nonwoven fabric comprising polyester with a soft resin such as polyurethane, a suede type pad prepared by forming a resin foam layer comprising polyurethane foam on a substrate such as a polyester nonwoven fabric, or a resin foam sheet comprising independently foamed polyurethane.

Then, a fluid such as air is fed to a fluid feed port **140** from a fluid feed mechanism (not shown). The fed fluid flows into the fluid chamber **174** from the flow path **175** after passing through the tube **131b.** The flow-in fluid adjusts the pressure in the fluid chamber **174** to adjust the pressing pressure of the carrier 166 and the retainer ring **167** onto the polishing pad **402.** The carrier **166** and the retainer ring **167** are supported with the diaphragm **165** and has a floating structure, by which each member is able to independently displace along the ascending and descending directions. The pressing pressure onto the polishing pad **402** is adjustable by the pressure in the fluid chamber **174.**

The platen is allowed to rotate and the wafer holding head **160** is allowed to undergo a planetary motion, while adjusting the pressing pressure of the carrier **166** and the retainer ring **167** onto the polishing pad **402.** The wafer **W** is polished by feeding the slurry from a slurry feed device onto the surface of the polishing pad **402** and on the polishing face of the wafer **W**.

Subsequently, the positions of the wafer **W** and the polishing pad **402** are adjusted by turning respective positioning handle while confirming that the wafer **W** is polished under best conditions. Polishing conditions of the wafer **W** can be confirmed using a polishing resistance sensor or by visual observation. Since the wafer holding head **160** is positioned along the direction of height by screwing the positioning external thread **136** into the positioning internal thread **143,** fine tuning in µm unit is easy.

While the positioning handle **138** is manually operated, an automatic positioning using a various kinds of actuators such as a servo motor or a stepping motor is also possible.

The positioning external thread **136** at outside of the bearing supporting member **135,** the positioning internal thread **143** screwed to the positioning external thread **136** and formed in the spindle housing **146,** and the handle supporting member **139** fixed to the bearing supporting member **135** for turning the bearing supporting member **135** and having the positioning handle **138,** are provided in respective spindles **131,** which support a plurality of the wafer holding heads **160,** as positioning mechanisms along the direction of height of the wafer holding heads **160**. Consequently, the main shaft **131a** can be shifted along the axis line direction by turning the bearing supporting member **135** together with the handle supporting member **139.**

Therefore, fine-tuning of the wafer holding heads **160** is made easy while fine-tuning the positions of the wafer **W** and the polishing pad **402.** In addition, all the wafers **W** are securely polished by independently positioning respective wafer holding heads **160,** even when a plurality of the wafer holding heads **160** are provided.

The polishing work can securely cope with changes of processing conditions during polishing by making fine-tuning of positions along the axis line direction possible during polishing of the wafer **W.** The change of the processing conditions as cited herein refers to the cases where, for example, the pressing force to each wafer **W** differs due to a slight change of the pressure in the fluid chamber **174** for each wafer holding head **160,** the lower face of the retainer ring **167** on each wafer holding head **160** is differently deteriorated, or the thickness of the polishing pad **402** is gradually reduced.

The wafer polishing apparatus **300** shown in FIG. 19 is provided with rotatable three platens **301,** polishing pads **302a** and **302b** for primary polishing and a polishing pad **302c** for secondary polishing, two-branched arms **303** supported with a pivot **303a** so as to be able to freely pivot, a wafer holding head **304** provided at each tip of the arm **303,** and a dresser **306** that can linearly travel along a guide **305** provided along the radial direction of each polishing pad **302.** Although the wafer supported by the wafer holding head **304** is polished with each polishing pad **302,** fine-tuning of the wafer holding head **304** along the axis line direction is difficult.

While the wafer holding head **304** supported with the arm **303** is allowed to pivot over the polishing pads **302a** to **302c,** it is difficult to obtain an optimum polishing condition for each polishing pad since each polishing pad is made of a different material and has a different thickness. Although it is possible to previously set a lower limit position of the arm **303** for each polishing pad, the method involves a problem that the thickness of each polishing pad changes by polishing and dressing, or the overall construction of the apparatus turns out to be complicated.

However, the optimum height of each wafer holding head **160** can be individually adjusted, easily and cheaply, using, for example, a stepping motor.

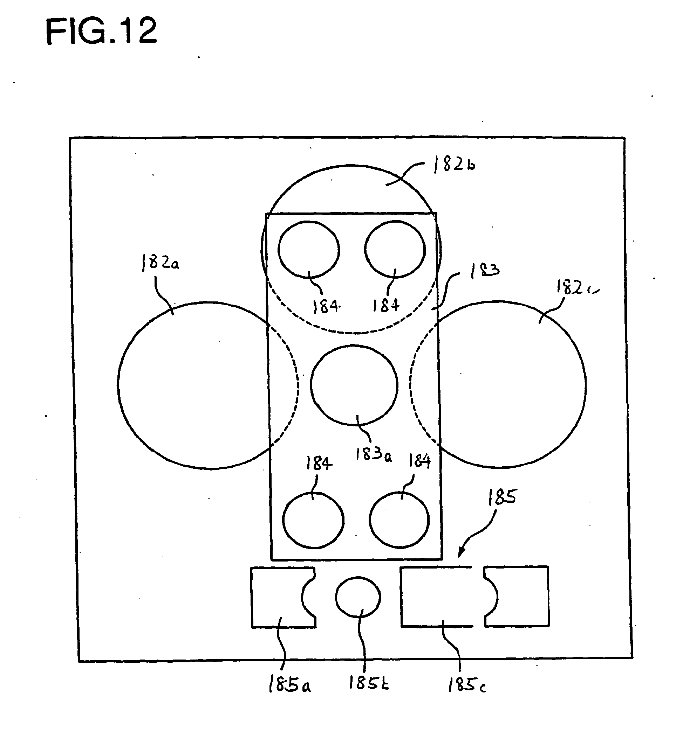

It is difficult to position the optimum elevation of the wafer holding head **184** against each polishing head in the apparatus in which the lower limit of the arm **183** position is adjustable, wherein a plurality of wafer holding heads **184** are attached at both ends of the linear arm **183,** and the wafer held on each wafer holding head **184** is polished with a different polishing pad as shown in FIG. 12. The apparatus shown in FIG. 12 is provided with arms **183** that are able to pivot around a pivot **183a,** two wafer holding heads **184** provided at the tip of respective arm **183,** polishing pads **182a, 182b** and 1**82c** disposed at an angle of 90 degree with each other along the horizontal direction, and a load-unload station **185** in opposed relation to the polishing pad **182b.** When two wafer holding heads **184** at one end of the arm **183** are polishing using the polishing pad **182,** the two wafer holding heads **184** at the other end receive and deliver at the load-unload station **185** provided with a supply cassette **185a,** a robot **185b** and a slider **185c**. When the arm **183** rotates at an angle of 90 degree along the horizontal direction, on the other hand, the wafer holding head **184** at one end polish the wafer with the polishing pad **182a** and the wafer holding head **184** at the other end polish the wafer with the polishing pad **182c.**

A plurality of the wafer holding head **184** can also be positioned at an optimum elevation by providing a height positioning mechanism according to the present invention, even in the wafer polishing apparatus constructed as described above.

### [Sixth Embodiment]

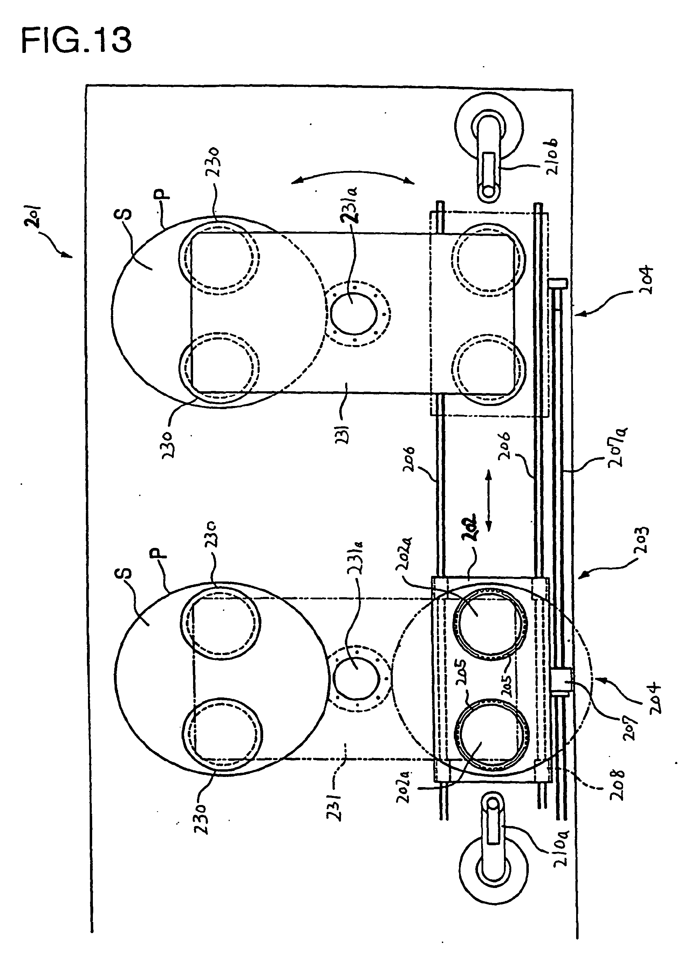

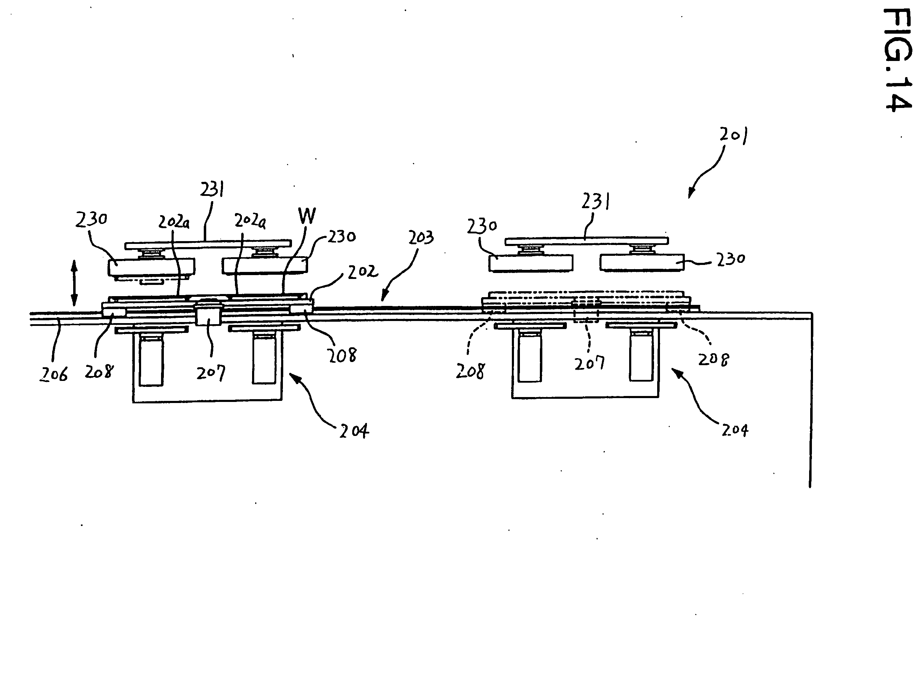

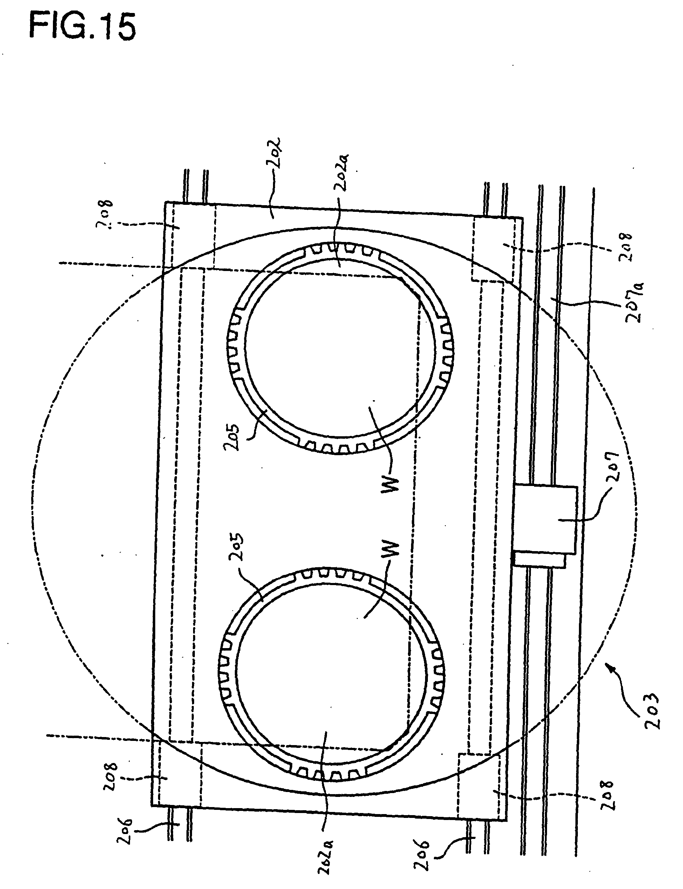

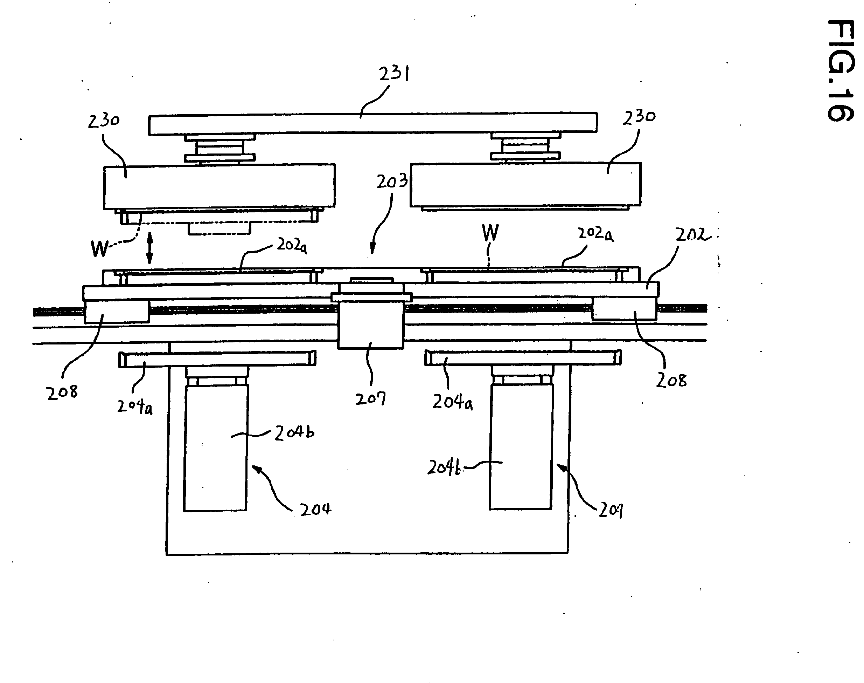

The wafer transfer apparatus and the wafer polishing apparatus, and the method for manufacturing the wafer in a sixth embodiment useful for understanding the present invention but not falling within the scope of the claims will be described hereinafter with reference to the drawings. FIG. 13 shows a plan view viewed from upward of the wafer polishing apparatus **201** according to the present invention, and FIG. 14 shows a side view of the apparatus in FIG. 14. FIGs. 15 and 16 show enlarged drawings of the apparatus shown in FIGs. 13 and 14, respectively.

In these drawings, the overall apparatus is provided with a tray **202** capable of mounting a plurality of wafers **W,** a tray travelling mechanism **203** for supporting the tray **202** so as to be able to travel, and a wafer attaching-detaching mechanism **204** provided under the tray travelling mechanism **203.**

The tray **202** formed into a rectangular shape in the plan view is provided with two holes **202a** having approximately the same diameter as the wafer **W.** An engage member **205** formed into a ring-shaped cogwheel is provided at each hole **202a,** and the wafer **W** is supported with the tray **202** by mounting its periphery on the engage member **205.**

The tray travelling mechanism **203** is provided with a guide rail **206** for supporting the tray **202** so as to freely travel along the horizontal direction, and a driving mechanism **207** for allowing the tray **202** to travel along the guide rail **206.** A linear bush holder **208** fitted to the guide rail **206** is coupled to both sides of the tray **202,** which travels along the longitudinal direction of the guide rail **206** by allowing the linear bush holder **208** to slide along the guide rail **206.**

A driving mechanism **207** coupled to a drive rail **207a** placed in parallel to the guide rail **206** is provided at one end of the tray **202.** For example, a linear motor is used for the driving mechanism **207.** The tray **202** travels along the horizontal direction toward the longitudinal directions of the guide rail **206** and the drive rail **207a**. One tray **202** that travels along the right and left directions is provided as shown in FIG. 13.

An upstream side robot arm **210a** and a downstream side robot arm **210b** are provided at the upstream side and downstream side, respectively, of the travel directions of the tray **202.** The upstream side robot arm **210a** receives the wafer **W** from the wafer accommodation member accommodating the wafer **W** to be polished, holds one face of the wafer **W** by a wafer adsorption mechanism provided at its tip, and mounts the wafer **W** on the engage member **205** provided in the hole **202a** on the tray **202.** The upstream side robot arm **210a,** which is provided to be able to pivot between the wafer accommodation member and the tray **202,** pivots to above the closer hole **202a** between the wafer accommodation member and the tray **202** while adsorbing the wafer **W** to be polished on its tip, and mount the wafer **W** by desorbing.

Likewise, the downstream side robot arm **210b** is also provided so as to be able to pivot between the tray **202** that has allowed to travel to the downstream side and, for example the accommodation member of the polished wafer, and accommodates the polished wafer, held by the wafer adsorption mechanism at the tip of the arm, in the polished wafer accommodation member.

The tray **202** is provided to be freely rotatable along the horizontal direction, and rotates to allow a plurality of holes **202a** to approach respective robot arms **210a** and **210b,** when the tray travels to respective robot arms **210a** and **210b** to receive and deliver the wafer **W**.

Polishing pads **S,** affixed on the surface of the platen **P** so as to be parallel to the travel direction of the tray **202,** are provided at two positions separated from the guide rail **206.** The upstream side (left side in FIG. 13) polishing pad **S** of the two pads is used for primary polishing, while the downstream side (right side in FIG. 13) polishing pad **S** is used for secondary polishing, each having a different material. Respective platens **P** are supported to be freely rotatable, and the polishing pad **S** is allowed to rotate by rotation of the platen **P.**

Any materials that have been conventionally used for polishing the wafer **W** may be used for the polishing pad **S,** examples of them including a velour type pad prepared by impregnating a nonwoven fabric comprising polyester with a soft resin such as polyurethane, a suede type pad prepared by forming a resin foam layer comprising polyurethane foam on a substrate such as a polyester nonwoven fabric, or a resin foam sheet comprising independently foamed polyurethane. The material of each polishing pad can be replaced depending on the purpose of polishing the wafer **W**.

Two wafer holding heads **230** are disposed above the upstream side and downstream side polishing pads **S**, respectively. The wafer holding heads **230** are supported to be freely rotatable at the tips of the head driving mechanisms **231** formed to have a rectangular plane view, and the trays are disposed with the same distance as the distance between the holes **202a** of the tray **202.** The two head driving mechanisms **231** are supported with a shaft **231a** providing a rotation power source so as to be able to freely pivot. The wafer holding heads **230** travel between the upper part of the polishing pad **S** and the upper part of the traveling path of the tray **202,** by allowing the head driving mechanisms **231** to pivot.

A plurality of the wafer attaching-detaching mechanism **204** are provided along the travel direction of the tray **202** below the guide rail **206** of the tray travelling mechanism **203.** Two wafer attaching-detaching mechanisms **204** are provided so as to have the same distance as the distance of the two wafer holding heads **230** provided at the head driving mechanism **231.** In total four wafer attaching-detaching mechanisms are provided so as to correspond to respective two head driving mechanism **231.**

The tray **202** is provided so as to travel above the wafer attaching-detaching mechanisms **204**. The wafer attaching-detaching mechanisms **204** is provided with an arm **204a** for supporting the lower face of the wafer **W,** and an ascending-descending mechanism **204b** for ascending and descending by allowing the arm **204a** to penetrate the hole **202a.** An air cylinder is used, tor example for the ascending-descending mechanism **204b.** The lower face of the wafer **W** transferred above the wafer attaching-detaching mechanisms **204** is supported with the arm **204a,** and is allowed to ascend and descend between the tray **202** and the lower face of the wafer holding head **230.**

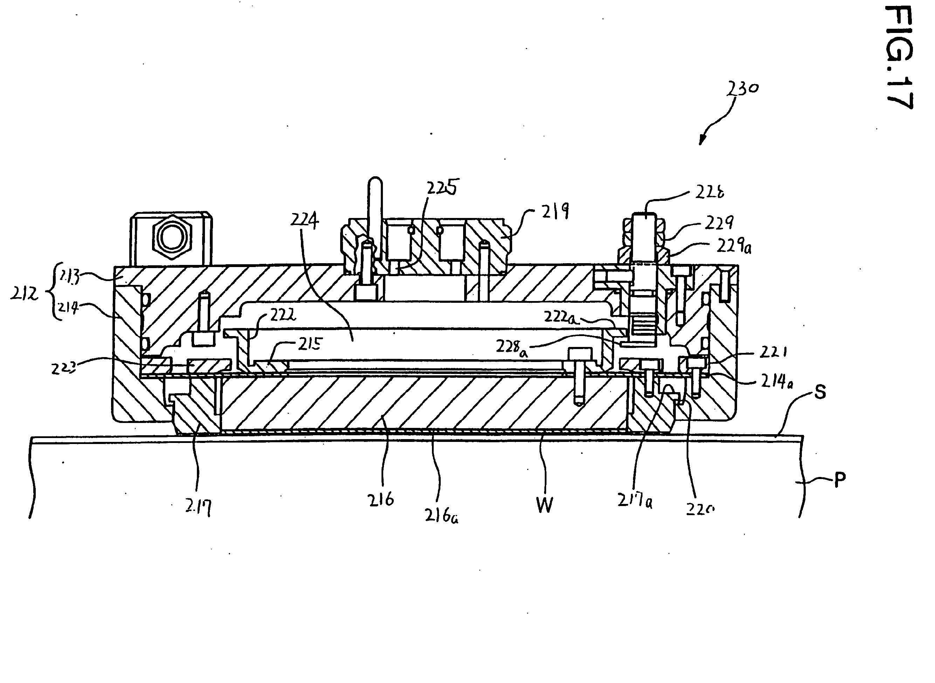

The wafer holding head **230** is provided with a head body **212** comprising a top plate **213** and a cylindrical circumference wall **214,** a diaphragm **215** expanded in the head body **212,** a disk-shaped carrier **216** fixed to the lower face of the diaphragm **215,** a ring-shaped retainer ring **217** provided in concentric relation to the inner wall of a circumference wall **214** and the outer circumference face of the carrier **216** as shown in FIG. 17.

The head body **212** is composed of the disk-shaped top plate **213** and the cylindrical circumference wall **214** fixed at the lower part of the outer circumference of the top plate **213,** and the head body **212** has a open hollow lower end. The top plate **213** is fixed in coaxial relation to a shaft **219,** and a flow path **225** communicating with the pressure adjustment mechanism (not shown) is formed in the shaft **219** along the vertical direction. A step **214a** and a ring-shaped locking member **220** protruding inside along the radial direction are formed over the entire circumference at the lower end of the circumference wall **214.**

The diaphragm **215** comprising an elastic material such as a fiber reinforced rubber is formed into a ring shape or a disk shape, and is fixed on the step **214a** with a diaphragm fixing ring **221** formed on the inner wall of the circumference wall **214.**

A fluid chamber **224** is formed above the diaphragm **215,** and communicates with a flow path **225** formed in the shaft **219.** The pressure in a fluid chamber **224** is controlled by feeding a fluid such as air in the fluid chamber **224** through the flow path **225** from a pressure adjustment mechanism (not shown).

The carrier **216** comprising a highly rigid material such as a ceramic is formed approximately into a cylinder having a given thickness, and is fixed with a carrier fixing ring **222** provided on the upper face of the diaphragm **215.** A ring-shaped step **222a** is formed at the upper part of the carrier fixing ring **222,** and engages with a step **228a** formed at the lower end of stopper bolts **228** fixed with nuts **229,** penetrating through the top plate **213** along the vertical direction, and a spacer **229a.** Consequently, the diaphragm **215** does not suffer an excess force by allowing the step **222a** to engage with the step **228a**, even when the diaphragm **215** is bent downward by the weight of the carrier **216** by allowing the wafer holding head, for example, to ascend with an ascending-descending mechanism.

The retainer ring **217** is formed into a ring shape between the inner wall of the circumference wall **214** and the outer circumference face of the carrier **216**, and is disposed in a concentric relation to the inner wall of the circumference wall **214** and the outer circumference face of the carrier **216** with a slight gap from the circumference wall **214** and the outer circumference face of the carrier **216.** The retainer ring **217** has horizontal upper and lower end faces, and are fixed with a retainer fixing ring **223** provided at the upper face of the diaphragm **215.** The step **217a** is formed on the outer circumference face of the retainer ring **217.** The diaphragm **215** is prevented from suffering a local force by suppressing excess downward movement of the retainer ring **217,** by allowing the step **217a** to engage with the locking member **220** when the wafer holding head ascends with the ascending-descending mechanism.

Various kinds of wafer holding head **230,** for example an apparatus in which the head polishing mechanism **231** and the wafer holding head **230** is supported with a ball bearing so as to be freely inclined, may be used.

The operations of the wafer transfer apparatus and the wafer polishing apparatus constructed as described above will be described hereinafter.

The wafer **W** to be polished accommodated in the wafer accommodation member is taken out with the upper stream side robot arm **210a,** for mounting the wafer **W** to be polished on the tray **202.** The upper face of the wafer **W** to be polished is held with a wafer adsorption mechanism provided at the tip of the upper stream side robot arm **210a.**

The upper stream side robot arm **210a** holding the wafer **W** is allowed to pivot above the travelling path of the tray **202.** The tray travels at the upper stream side robot arm **210a**. Then, the wafer **W** held by the upper stream side robot arm **210a** is disposed above the closer hole **202a** of the two holes **202a** formed on the tray **202.** The wafer **W** is mounted on the engage member **205** provided in the hole **202a,** by releasing the wafer **W** from the wafer adsorption mechanism.

After supporting one hole **202a** of the two holes **202a** formed in the tray **202,** the tray **202** is allowed to rotate. The other hole **202a** is disposed to come close to the upstream side robot arm **210a** by allowing the tray **202** to rotate. Subsequently, the wafer **W** to be polished is taken out of the wafer accommodation member with the upstream side robot arm **210a** as described above, and the wafer **W** is mounted on the other hole **202a**, thereby two wafers **W** to be polished are mounted on the tray **202.**

The tray **202** on which the wafers **W** to be polished are mounted is allowed to horizontally travel toward the upstream side along the guide rail **206** by allowing the driving mechanism **207** to actuate, while the two wafer holding heads **230** are disposed at the guide rail **206** side that lies on the travel path of the tray **202** by allowing the head driving mechanism **231** to pivot. The wafer holding head **230** moved on the travel path of the tray **202** is positioned in opposed relation to the wafer attaching-detaching mechanism **204**.

The tray **202** mounting the wafer **W** to be polished allows the wafer **W** to travel so as to be disposed between the wafer holding heads **230** and the wafer attaching-detaching mechanism **204,** and stops there.

Respective arms **204a** of the wafer attaching-detaching mechanism **204** ascend after the operation described above, and respective wafers **W** mounted on the locking member **205** of the hole **202a** are supported from below with the arm **204a.** The wafer **W** comes close to the wafer holding head **230** by further ascending the arm **204a** to hold the wafer on the lower face of the wafer holding head. Thus, the wafer **W** is affixed on the wafer affixing sheet **216a** (an insert) provided on the lower face of the carrier **216,** and the periphery of the wafer **W** is locked with the retainer ring **217.**

The head driving mechanism **231** pivots for polishing the wafer **W** attached to the wafer holding head **230,** the wafer holding head **230** holding the wafer **W** to be polished is disposed above the polishing pad **S** to allow the surface of the wafer to contact the polishing pad **S** affixed on the surface of the platen **P.**

The pressure in the fluid chamber **224** is adjusted by allowing a fluid such as air to flow into the fluid chamber **224** from the flow path **225** to adjust the pressing pressure of the carrier **216** and the retainer ring **217** onto the polishing pad **S**. The carrier **216** and the retainer ring **217** has planar structures supported with the diaphragm **215** by which the carrier **216** and the retainer ring **217** are independently able to displace along the ascending and descending directions. The pressing pressure onto the polishing pad **S** is adjustable by the pressure in the fluid chamber **224.**

The primary polishing of the wafer **W** is carried out by allowing the wafer **W** held on the wafer holding head **230** to rotate on the polishing pad **S**.

When the primary polishing of the wafer **W** has completed, the head driving **231** mechanism is again allowed to pivot, thereby the tray **202** that has been moved above the wafer attaching-detaching mechanism **204** is allowed to oppose the wafer **W**. The arm **204a** of the wafer attaching-detaching mechanism **204** ascends while the tray **202** penetrates through the hole **202a** from below. The lower face of the wafer **W** is supported with the arm **204a,** and the wafer **W** is released from the wafer holding head **230** to mount it on the arm **204a.** The wafer **W** after the primary polishing is loaded on the tray **202** by descending the arm **204a** supporting the wafer **W**.

The wafer **W** after completing the primary polishing is attached to the downstream side wafer holding head **230** for the secondary polishing. The tray **202** mounting the wafer **W** travels toward the downstream, and disposed above the downstream side wafer attaching-detaching mechanism **204.** Then, as in the primary polishing, the head driving mechanism **231** at the downstream side is allowed to pivot to dispose the downstream side wafer attaching-detaching mechanism **204** above the tray **202.** The wafer **W** after completing the primary polishing is attached to the wafer holding head **230** for the secondary polishing. The wafer is polished by allowing the wafer holding head **230** on the upper face of the secondary polishing pad **S** by pivoting the head driving mechanism **231**.

It is possible to deliver the wafer **W** to be polished, which is accommodated in the wafer accommodation member, using the upstream side robot arm **210a** on way of the secondary polishing of the wafer **W**, by allowing the tray **202** to move toward the upstream side. The wafer **W** to be polished is held with the wafer holding head **230** after traveling toward the downstream side for the primary polishing of the wafer. In other words, the primary polishing and the secondary polishing are independently and simultaneously carried out by providing a time lag between the primary polishing and the secondary polishing.

The wafer **W** after completing the secondary polishing is mounted on the tray **202** with the downstream side wafer attaching-detaching mechanism, as in the primary polishing. The tray **202** has traveled toward the downstream side after delivering the wafer to the wafer holding head **230** for the primary polishing. The tray **202** mounting the wafer **W** after completing the secondary polishing is transferred to the downstream side robot arm **210b** with the driving mechanism **207.** One face of the wafer **W** is held with the wafer adsorption mechanism of the downstream side robot arm **210b**, and the wafer is accommodated in the polished wafer accommodation member by allowing the robot arm **210b** to pivot.

The tray **202** after delivering the polished wafer **W** to the downstream side robot arm **210b** travels toward the upstream side again, in order to receive the wafer **W** after the primary polishing and to transfer it to the secondary polishing step. Accordingly, the tray **202** is constructed to be able to freely travel for receiving the wafer **W** from and for delivering wafer **W** to the upstream side and downstream side robot arms **210a** and **210b,** and the primary and secondary wafer holding heads **230.**

The tray **202** horizontally transfers the wafer **W**. The wafer **W** is attached to and detached from the wafer holding head **230** by allowing the tray **202** to travel below the wafer holding head **230** using the wafer attaching-detaching mechanism **204** provided there. Consequently, individual mechanism becomes simple and compatible for high speed operation, besides reliability the apparatus is improved to make maintenance easy.

In the construction in which the transfer mechanism and the attaching-detaching mechanism are separated with each other, the tray **202** may rapidly and accurately perform horizontal linear traveling and stop at the destination, while the wafer attaching-detaching mechanism may rapidly and accurately attach the wafer **W** to and detach from the wafer holding head **230.** In other words, the mechanisms rapidly and accurately operate without making the control system for controlling the operation of respective mechanisms complicated. Therefore, each function is made to be high speed with reliable operation, besides making maintenance easy.

The wafer attaching-detaching mechanism **204** is placed with a distance apart from the polishing pad **S** as a polishing mechanism of the wafer **W**, and the wafer holding head **230** travels between above the polishing pad **S** and the above the wafer attaching-detaching mechanism **204** by pivoting the head driving mechanism **231**. The wafer holding head **230** travels above the wafer attaching-detaching mechanism **204**, on the other hand, when the wafer is attached to and detached from the wafer holding head **230,** while the wafer holding head **230** travels above the polishing pad **S** when the wafer **W** is polished. Consequently, the attaching and detaching operations of the wafer **W** is securely carried out with no interaction with each other, thereby making the respective mechanisms simple.

The tray **202** is supported to be able to freely travel between below the wafer holding head **230** and above the wafer attaching-detaching mechanism **204,** while the wafer attaching-detaching mechanism **204** provides the arm **204** that is able to ascend and descend. Therefore, the wafer **W** on the tray **202** transferred to below the wafer holding head **230** is securely attached to and detached from the wafer holding head **230** using the arm **204a.**

A plurality of the polishing pads **S** as polishing mechanisms of the wafer **W,** and a plurality of the wafer holding heads **230** are provided along the travel direction of the tray **202.** Consequently, different kinds of girding such as the primary and secondary polishing can be simultaneously performed using different polishing pads **S** and abrasive depending on respective polishing mechanisms.

The tray **202** is allowed to travel above the plural wafer attaching-detaching mechanisms **204** corresponding to the polishing mechanisms as described above, while respective wafer holding heads **230** are provided so that they can independently travel with a time lag on the traveling path of the tray **202** by allowing the head driving mechanism **231** to pivot. Consequently, the attaching step of the wafer **W** to and the detaching step of the wafer **W** from the wafer holding heads **230,** and polishing step of the wafer **W** become independent with each other, reducing the pause interval among the steps. Accordingly, throughput of the process is improved to allow the wafer **W** to be efficiently polished and transferred.

The tray **202** is able to travel while mounting a plurality of wafers **W**, which are efficiently transferred. Since the tray **202** is able to mount the wafer **W** while it is rotating even when a plurality of the wafers **W** are mounted by making the tray **202** to be rotatable, mounting of the wafers are made easy. In other words, it is possible to receive the wafer **W** from and deliver the wafer **W** to the tray **202** using the robot arms **210a** and **210b,** after allowing the tray **202** to rotate so that the hole **202a** of the tray **202** comes close to respective robot arms **210a** and **210b.** Consequently, the wafer **W** can be placed on each hole 202a without providing a flexible function in the robot arms **210a** and **210b.**

Since the tray **202** is freely rotatable, the construction of the robot arms **210a** and **210b** turn out to be simple, besides operating the apparatus at high speed and improving its reliability.

Advantageously, the present invention provides a wafer polishing apparatus and method for manufacturing the wafer, by which the wafer is efficiently polished by saving consumption of the slurry.

According to the polishing apparatus of the present invention, the slurry is held with the slurry pocket and the polishing pad, since the slurry pocket accommodating the slurry is formed at a part of the contact portion between the periphery of the wafer holding portion on the lower face of the wafer holding head, and the polishing pad. Consequently, the amount of the slurry flowing out by centrifugal force is diminished even when the polishing pad affixed on the platen rotates. The slurry in the slurry pocket is uniformly fed on the surface of the polishing pad, by allowing the wafer holding pad and the platen to rotate, thus enabling the wafer to be efficiently polished.

According to embodiments of the wafer polishing apparatus of the present invention, the amount of the flowing out abrasive can be reduced by providing the slurry holding ring.

Advantageously, with the methods for manufacturing the wafer in the present invention, the wafer is efficiently polished using a minimum amount of the slurry, because the slurry is fed into the wafer holding head. Also, flowing out of abrasive due to rotation of the platen is suppressed to reduce the amount of use of the slurry, because the wafer is polished while allowing the wafer holding head to contact the polishing pad so that the opening of the slurry pocket is blocked with the polishing pad.

## Claims

1. A wafer polishing apparatus (1, 101, 115, 201) comprising:
a platen (P, 104, 120, 403);
a polishing pad (Su, 106, 121, 402, 182a-c, S) affixed on a surface of the platen; and
a wafer holding head (41) comprising a carrier (46), for allowing one face of a wafer (W) to contact the polishing pad by holding the wafer to be polished, the wafer being polished, in use of the apparatus, with the polishing pad by a relative motion between the wafer holding head and the platen, and a retainer ring (47) which is provided so as to be displaceable along a head axis direction for locking a periphery of the wafer while making contact with the polishing pad during polishing of the wafer,
**characterized in that** the water polishing apparatus, further comprises:
a slurry pocket (66), which is formed on a lower face of the retainer ring, for contacting the polishing pad and distributing a slurry equally; and
a retainer ring tube (65) formed in the retainer ring and communicating with a slurry feed member (61).

2. A wafer polishing apparatus according to Claim 1, wherein the wafer holding head (41) further comprises:
a head body (42) comprising a top plate (43), and a cylindrical circumference wall (44) provided below an outer circumference of the top plate;
a diaphragm (45) substantially vertically expanded to the head axis line in the head body; and
a pressure adjustment means (60) for adjusting the pressure of a fluid filled in a fluid chamber (54) formed between the diaphragm and the head body, wherein:
the carrier (46) is fixed to the diaphragm and is provided so as to be displaceable along the head axis direction, for holding one face of the wafer to be polished;
the retainer ring (47) is fixed to the diaphragm and is disposed in concentric relation between an inner wall of the circumference wall (44) and an outer circumference of the carrier (46); and
the slurry pocket (66) communicates with the slurry feed member (61).

3. A wafer polishing apparatus according to Claim 1, wherein the wafer holding head further comprises:
a head body (42) comprising a top plate (43), and a cylindrical circumference wall (44) provided below an outer circumference of the top plate;
a diaphragm (45) substantially vertically expanded to the head axis line in the head body; and
a pressure adjustment means (60) for adjusting the pressure of a fluid filled in a fluid chamber (54) formed between the diaphragm and the head body, wherein:
the carrier (46) is fixed to the diaphragm and is provided so as to be displaceable along the head axis line direction together with the diaphragm, for holding one face of the wafer (W) to be polished;
the retainer ring (47) is fixed to the diaphragm while being disposed in concentric relation between an inner wall of the circumference wall (44) and an outer circumference of the carrier (46);
a head body tube (63) is formed in the head body, and communicates with the slurry feed member (61); and
a flexible tube (64) comprising a flexible member is connected between the head body tube (63) and the retainer ring tube (65).

4. A wafer polishing apparatus (1, 101, 115, 201) comprising:
a platen (P, 104, 120, 403);
a polishing pad (Su, 106, 121, 402, 182a-c, S) affixed on a surface of the platen;
a wafer holding head (71) comprising a carrier (76) for allowing one face of a wafer (W) to contact the polishing pad by holding the wafer to be polished, the wafer being polished, in use of the apparatus, with the polishing pad by a relative motion between the wafer holding head and the platen, a circumference wall (74) forming part of a head body (72), and a retainer ring (77) which is provided so as to be displaceable along a head axis direction for locking a periphery of the wafer while making contact with the polishing pad during polishing the wafer; and
an outer ring (95) which is disposed in concentric relation to the wafer holding head (71) and is provided so as to be displaceable along the head axis direction, for making contact with the polishing pad during polishing at the outside of the wafer holding head (71),
**characterized in that** the wafer polishing apparatus further comprises:
a slurry pocket (97) which is formed between the retainer ring (77) and the outer ring (95), for contacting the polishing pad and distributing the slurry equally; and
a head body tube (93) formed in the circumference wall (74), and communicating with a slurry feed member (91).

5. A wafer polishing apparatus according to Claim 1, wherein the wafer holding head (41) further comprises:
a head body (42) comprising a top plate (43) and a cylindrical circumference wall (44) provided below the outer circumference of the top plate;
a diaphragm (45) substantially vertically expanded to the head axis line in the head body; and
a pressure adjustment means (60) for adjusting the pressure of a fluid filled in a fluid chamber (54) formed between the diaphragm (45) and the head body (42), wherein:
the carrier is fixed to the diaphragm and is provided so as to be displaceable together with the diaphragm along the head axis direction, for holding one face of a wafer (W) to be polished;
the retainer ring (47) is disposed in concentric relation between an inner wall of the circumference wall (44) and an outer circumference of the carrier (46), and is fixed to the diaphragm, and is provided so as to be displaceable along the head axis direction together with the diaphragm, for making contact with the polishing pad during polishing,
the retainer ring (47) is disposed in concentric relation to an inner wall of the circumference wall (44); and
the slurry pocket (66) communicates with the slurry feed member (61) through a head body tube (63) formed so as to penetrate into a lower face of the circumference wall (44).

6. A wafer polishing apparatus (1, 101, 115, 201) comprising:
a platen (P, 104, 120, 403);
a polishing pad (Su, 106, 121, 402, 182a-c, S) affixed on a surface of the platen; and
a wafer holding head for holding a wafer to be polished, and for allowing one face of the wafer to contact the polishing pad, the wafer being polished, in use of the apparatus, with the polishing pad by a relative motion between the wafer holding head and the platen,
**characterized in that** the wafer polishing apparatus further comprises:
a slurry holding ring (117), which is allowed at its lower face to contact the polishing pad, which is disposed so as not to contact the periphery of the wafer holding head, and which is provided at the outside of the wafer holding head to be rotatable with respect to the wafer holding head; and
a slurry feed member (119) configured and arranged to feed a slurry between an outer circumference of the wafer holding head and an inner circumference of the slurry holding ring.

7. A wafer polishing apparatus according to Claim 6, wherein an outlet (117a) for discharging a slurry to outside is formed at a part of a wall of the slurry holding ring (117).

8. A wafer polishing apparatus according to Claim 6 or 7, wherein an outlet (117a) for discharging a slurry to outside is formed at a part of a wall of the slurry holding ring (117).

9. A method for manufacturing a wafer comprising:
a step for providing a platen (P, 104, 120, 403) on a surface of which a polishing pad (Su, 106, 121, 402, 182a-c, S) is affixed, a wafer holding head (41, 71) comprising a carrier (46, 76) for allowing one face of a wafer (W) to contact the polishing pad by holding the wafer to be polished, and a retainer ring (47, 77) for locking a periphery of the wafer while making contact with the polishing pad during polishing of the wafer, the retainer ring having a retainer ring tube (65) formed therein communicating with a slurry feed member (61); and
a polishing step for polishing the wafer with the polishing pad by a relative motion between the wafer holding head and the platen, **characterized in that**:
a slurry pocket (66), which is formed on a lower face of the retainer ring for feeding a slurry, is provided at the periphery of a wafer holding portion on a lower face of the wafer holding head;
the wafer holding head is allowed to rotate while allowing the lower face of the wafer holding head to contact the polishing pad; and
the wafer is polished by feeding a slurry onto the face of the wafer and a surface of the polishing pad while suppressing the slurry fed to the slurry pocket (66) from flowing out.

10. A method for manufacturing a wafer comprising:
a step for providing a platen (P, 104, 120, 403) on the surface of which a polishing pad (Su, 106, 121, 402, 182a-c, S) is affixed, and a wafer holding head (116, 160, 184, 230) comprising a carrier (166, 216) for allowing one face of a wafer to contact the polishing pad by holding the wafer to be polished and a retainer ring (167, 217) provided for locking a periphery of the wafer while making contact with the polishing pad during polishing the wafer; and
a polishing step for polishing the wafer with the polishing pad by a relative motion between the wafer holding head and the platen, **characterized in that**:
a slurry holding ring (117) is provided so as to contact the polishing pad and not to contact an outer circumference of the wafer holding head, and is disposed at an outside of the wafer holding head;
a slurry is fed by a slurry feed member (119) between the outer circumference of the wafer holding head and the slurry holding ring while allowing the wafer holding head to rotate with respect to the slurry holding ring; and
the wafer is polished while preventing the slurry from flowing out by the slurry holding ring (117).

## Patentansprüche

1. Halbleiterscheiben-Poliervorrichtung (1, 101, 105, 201) umfassend:
eine Platte (P, 104, 120, 403);
ein Polierkissen (Su, 106, 121, 402, 182a - c, S), das auf einer Oberfläche der Platte fixiert ist; und
einen Halbleiterscheiben-Haltekopf (41), der einen Träger (46) zur Ermöglichung des Kontakts einer Fläche der Halbleiterscheiben (W) mit dem Polierkissen durch Halten der zu polierenden Halbleiterscheibe umfasst, wobei die Halbleiterscheibe durch Verwendung der Vorrichtung mit dem Polierkissen durch eine relative Bewegung zwischen den Halbleiterscheiben-Haltekopf und der Platte poliert wird, und ein Rückhaltering (47), der so vorgesehen ist, dass er entlang einer Kopfachsrichtung zur Verriegelung eines Umfangs der Halbleiterscheibe verschiebbar ist, während ein Kontakt mit dem Polierkissen während dem Polieren der Halbleiterscheibe gewährleistet wird,
**dadurch gekennzeichnet, dass** die Halbleiterscheiben-Poliervorrichtung des Weiteren umfasst:
eine Absetztasche (66), die auf einer unteren Fläche des Rückhalterings zum Kontakt mit dem Polierkissen und gleichmäßiger Verteilung des Polierschlamms ausgebildet ist; wobei ein Rückhaltering-Rohr (65) in dem Rückhaltering ausgebildet ist und in Wirkverbindung mit einem Schlammzufuhrelement (61) steht.

2. Halbleiterscheiben-Poliervorrichtung gemäß Anspruch 1, wobei der Halbleiterscheiben-Haltekopf (41) des Weiteren umfasst:
einen Kopfkörper (42), der eine obere Platte (43) und eine zylindrische Umfangswand (44) umfasst, die unterhalb eines äußeren Umfangs der oberen Platte vorgesehen ist; eine Blende (45), die im Wesentlichen vertikal zur Kopfachslinie im Kopfkörper erstreckt ist; und
ein Druckeinstellelement (60) zum Einstellen des Drucks eines in eine Fluidkammer (54), die zwischen der Blende und dem Kopfkörper ausgebildet ist, eingefüllten Fluids, wobei:
der Träger (46) an der Blende fixiert ist und so vorgesehen ist, dass er entlang der Kopfachsenrichtung zum Halten einer Fläche der zu polierenden Halbleiterscheibe verschiebbar ist;
der Rückhaltering (47) an der Blende fixiert ist und in konzentrischer Beziehung zwischen einer Innenwand der umfänglichen Wand (44) und einem äußeren Umfang des Trägers (46) angeordnet ist; und
die Absetztasche (66) mit dem Schlammzufuhrelement (61) in Wirkverbindung steht.

3. Halbleiterscheiben-Poliervorrichtung gemäß Anspruch 1, wobei der Halbleiterscheiben-Haltekopf des Weiteren umfasst:
einen Kopfkörper (42), der eine obere Platte (43) und eine unterhalb eines äußeren Umfangs der oberen Platte vorgesehene zylindrische Umfangswand (44) umfasst;
eine Blende (45), die im Wesentlichen zur Kopfachslinie im Kopfkörper erstreckt ist; und
ein Druckeinstellelement (60) zum Einstellen des Drucks eines in eine Fluidkammer (44), die zwischen der Blende und dem Kopfkörper ausgebildet ist, eingefüllten Fluids, wobei:
der Träger (46) an der Blende fixiert ist und derart vorgesehen ist, dass er entlang der Kopfachslinienrichtung zusammen mit der Blende zum Halten von einer Fläche der zu polierenden Halbleiterscheiben (W) verschiebbar ist; der Rückhaltering (47) an der Blende fixiert ist, während er in konzentrischer Beziehung zwischen einer Innenwand der Umfangswand (44) und einem äußeren Umfang des Trägers (46) angeordnet ist;
ein Kopfkörper-Rohr (63), das in dem Kopfkörper ausgebildet ist und mit dem Polierschlamm-Zufuhrelement (61) in Wirkverbindung steht; und ein flexibles Rohr (64), das ein flexibles Element umfasst, welches zwischen dem Kopfkörper-Rohr (63) und dem Rückhaltering-Rohr (65) angebunden ist.

4. Halbleiterscheiben-Poliervorrichtung (1, 101, 115, 201), umfassend:
eine Platte (P, 104, 120, 403);
ein Polierkissen (Su, 106, 121, 402, 182a - c, S), das an einer Oberfläche der Platte fixiert ist;
einen Halbleiterscheiben-Haltekopf (71), der einen Träger (76) umfasst, wodurch ermöglicht wird, das eine Fläche einer Halbleiterscheibe (W) durch Halten der zu polierenden Halbleiterscheibe das Polierkissen berührt, die Halbleiterscheibe bei Verwendung der Vorrichtung mit dem Polierkissen durch relative Bewegung zwischen dem Halbleiterscheiben-Haltekopf und der Platte poliert wird, eine Umfangswand (74) einen Teil eins Kopfkörpers (72) ausbildet, und ein Rückhaltering(77), der so vorgesehen ist, dass er entlang einer Kopfachsenrichtung zum Verriegeln des Umfangs einer Halbleiterscheibe verschiebbar ist, während in Kontakt mit dem Polierkissen während dem Polieren der Halbleiterscheiben hergestellt wird; und
einen äußeren Ring (95), der in konzentrischer Beziehung zu dem Halbleiterscheiben-Haltekopf (71) angeordnet ist und derart vorgesehen ist, dass er entlang der Kopfachsrichtung zur Bewirkung des Kontakts mit dem Polierkissen während dem Polieren an der Außenseite des Halbleiterscheiben-Haltekopfs (71) verschiebbar ist,
**dadurch gekennzeichnet, dass** die Halbleiterscheiben-Poliervorrichtung des Weiteren umfasst:
eine Absetztasche (97), die zwischen dem Rückhaltering (77) und dem äußeren Ring (95) zum Kontakt mit dem Polierkissen und zur gleichmäßigen Verteilung des Polierschlamms ausgebildet ist; und
ein Kopfkörper-Rohr (93) das in der Umfangswand (74) ausgebildet ist und mit dem Schlamm-Zufuhrelement (91) in Wirkverbindung steht.

5. Halbleiterscheiben-Poliervorrichtung gemäß Anspruch 1, wobei der Halbleiterscheiben-Haltekopf (41) des Weiteren umfasst:
einen Kopfkörper (42), der eine obere Platte (43) und eine unterhalb des äußeren Umfangs der oberen Platte vorgesehen zylindrische Umfangswand (44) umfasst;
eine Blende (45) die im Wesentlichen vertikal zur Kopfachslinie im Kopfkörper erstreckt ist; und
ein Druckeinstellelement (60) zum Einstellen des Drucks eines in eine Fluidkammer (54), die zwischen der Blende (45) und dem Kopfkörper (42) ausgebildet ist, gefülltes Fluid, wobei:
der Träger an der Blende fixiert ist und derart vorgesehen ist, dass er zusammen mit der Blende entlang der Kopfachsrichtung zum Halten einer Fläche einer zu polierenden Halbleiterscheiben (W) verschiebbar ist;
der Rückhaltering (47) in konzentrischer Beziehung zwischen einer Innenwand der Umfangswand (44) sowie einem äußeren Umfang des Trägers (46) angeordnet ist und an der Blende fixiert ist und so vorgesehen ist, dass er entlang der Kopfachsrichtung zusammen mit der Blende zum Erbringen eines Kontakts mit dem Polierkissen während des Polierens verschiebbar ist,
der Rückhaltering (47) in konzentrischer Beziehung zu einer Innenwand der Umfangswand (44) angeordnet ist; und
die Absetztasche (66) mit dem Polierschlamm-Zufuhrelement (61) durch ein Kopfkörper-Rohr (63), das derart ausgebildet ist, dass es in eine untere Fläche der Umfangswand (44) hinein eintritt, in Wirkverbindung steht.

6. Halbleiterscheiben-Poliervorrichtung (1, 101, 115, 201) umfassend:
eine Platte (P, 104, 120, 403);
ein Polierkissen (Su, 106, 121, 402, 182a-c, S), das an einer Oberfläche der Platte fixiert ist; und
einen Halbleiterscheiben-Haltekopf zum Halten einer zu polierenden Halbleiterscheibe und zur Ermöglichung, das eine Fläche der Halbleiterscheibe das Polierkissen berührt, die Halbleiterscheibe bei der Verwendung der Vorrichtung mit dem Polierkissen durch eine relative Bewegung zwischen dem Halbleiterscheiben-Haltekopf und der Platte poliert wird,
**dadurch gekennzeichnet, dass** die Halbleiterscheiben-Poliervorrichtung des Weiteren umfasst:
einen Polierschlamm-Haltering (117), dem ermöglicht wird, an seiner unteren Fläche das Polierkissen, welches so angeordnet ist, dass es nicht den Umfang des Halbleiterscheiben-Haltekopfs berührt und welches an der Außenseite des Halbleiterscheiben-Haltekopfs drehbar in Bezug auf den Halbleiterscheiben-Haltekopf vorgesehen ist, zu berühren; und
ein Schlamm-Zufuhrelement (119), das so aufgebaut und angeordnet ist, dass es einen Schlamm zwischen einem äußeren Umfang des Halbleiterscheiben-Haltekopfs sowie einem innen Umfang des Schlamm-Halterings zuführt.

7. Halbleiterscheiben-Poliervorrichtung gemäß Anspruch 6, wobei ein Auslass (117a) zum Ausgeben eines Schlamms nach außen an einem Teil einer Wand des Schlamm-Halterings (117) ausgebildet ist.

8. Halbleiterscheiben-Poliervorrichtung gemäß Anspruch 6 oder 7, wobei ein Auslass (117a) zum Ausgeben eines Schlamms nach außen an einem Teil einer Wand des Schlamm-Halterings (117) ausgebildet ist.

9. Verfahren zur Herstellung einer Halbleiterscheibe, umfassend:
einen Schritt der Bereitstellung einer Platte (P, 104, 120, 403) auf einer Oberfläche, an der ein Polierkissen (Su, 106, 121, 402, 182 a-c, S) fixiert ist, einen Halbleiterscheiben-Haltekopf (41, 71), der einen Träger (46, 76) umfasst, um seiner Fläche der Halbleiterscheibe (W) zu ermöglichen, das Polierkissen durch Halten der zu polierenden Halbleiterscheibe zu berühren, sowie einen Rückhaltering 847, 77) zum Verriegeln eines Umfangs der Halbleiterscheibe, während der Kontakt mit dem Polierkissen während des Polierens der Halbleiterscheibe bewirkt wird, wobei der Rückhaltering ein Rückhaltering-Rohr (65) aufweist, das darin in Wirkverbindung mit einem Schlamm-Zufuhrelement (61) ausgebildet ist; und
einen Polierschritt zum Polieren der Halbleiterscheibe mit dem Polierkissen mittels einer relativen Bewegung zwischen dem Halbleiterscheiben-Haltekopf und der Platte, **dadurch gekennzeichnet, dass**:
eine Absetztasche (66), die an einer unteren Fläche des Rückhalterings zur Zufuhr eines Polierschlamms ausgebildet ist, am Umfang eines Halbleiterscheiben-Halteabschnitts an einer unteren Fläche des Halbleiterscheiben-Haltekopfs vorgesehen ist;
dem Halbleiterscheiben-Haltekopf ermöglicht wird, zu rotieren, während es der unteren Fläche des Halbleiterscheiben-Haltekopf ermöglicht wird, das Polierkissen zu berühren; und
die Halbleiterscheibe durch Zufuhr eines Polierschlamms auf die Fläche der Halbleiterscheibe sowie einer Oberfläche des Polierkissens poliert wird, während das Ausströmen des zugeführten Polierschlamms zur Absetztasche (66) unterdrückt wird.

10. Verfahren zur Herstellung einer Halbleiterscheibe, umfassend:
einen Schritt der Bereitstellung einer Platte (P, 104, 120, 403) auf der Oberfläche, an der ein Polierkissen (Su, 106, 121, 402, 182a-c, S) fixiert ist, und einen Halbleiterscheiben-Haltekopf (116, 160, 184, 230), der einen Träger (166, 216) zur Ermöglichung, dass eine Fläche einer Halbleiterscheibe das Polierkissen durch Halten der zu polierenden Halbleiterscheibe berührt und ein Rückhaltering (167, 217), der zum Verriegeln eines Umfangs der Halbleiterscheibe während der Berührung mit dem Polierkissen während des Polierens der Halbleiterscheibe vorgesehen ist; und
einen Polierschritt zum Polieren der Halbleiterscheibe mit dem Polierkissen durch eine relative Bewegung zwischen dem Halbleiterscheiben-Haltekopf und der Platte, **dadurch gekennzeichnet, dass**:
ein Polierschlamm-Haltering (117) so vorgesehen ist, dass er das Polierkissen berührt und einen äußeren Umfang des Halbleiterscheiben-Haltekopfs nicht berührt und an einer Außenseite des Halbleiterscheiben-Haltekopfs angeordnet ist; ein Polierschlamm durch ein Schlamm-Zufuhrelement (119) zwischen dem äußeren Umfang des Halbleiterscheiben-Haltekopfs und den Polierschlamm-Haltering zugeführt wird, während es dem Halteiterscheiben-Haltekopf ermöglicht wird, in Bezug auf den Polierschlamm-Haltering zu rotieren; und
die Halbleiterscheibe poliert wird, während das Ausströmen des Polierschlamms durch den Polierschlamm-Haltering (117) verhindert wird.

## Revendications

1. Appareil de polissage de plaquette (1, 101, 115, 201) comprenant :
une platine (P, 104, 120, 403) ;
un tampon de polissage (Su, 106, 121, 402, 182 a à c, S) fixé sur une surface de la platine ; et
une tête de maintien de plaquette (41) comprenant un support (46), destiné à permettre à une face d'une plaquette (W) d'entrer au contact du tampon de polissage en maintenant la plaquette à polir, la plaquette étant polie, en utilisation de l'appareil, à l'aide du tampon de polissage par un mouvement relatif entre la tête de maintien de plaquette et la platine, et une bague de retenue (47) qui est disposée de façon à pouvoir être déplacée le long d'une direction d'axe de tête pour verrouiller une périphérie de la plaquette tout en faisant contact avec le tampon de polissage pendant le polissage de la plaquette,
**caractérisé en ce que** l'appareil de polissage de plaquette comprend en outre :
une poche de suspension épaisse (66), qui est formée sur une face inférieure de la bague de retenue, destinée à entrer au contact du tampon de polissage et à distribuer une suspension épaisse de manière égale ; et
un tube de bague de retenue (65) formé dans la bague de retenue et communiquant avec un organe d'alimentation en suspension épaisse (61).

2. Appareil de polissage de plaquette selon la revendication 1, dans lequel la tête de maintien de plaquette (41) comprend en outre :
un corps de tête (42) comprenant une plaque supérieure (43) et une paroi circonférentielle cylindrique (44) disposée sous une circonférence externe de la plaque supérieure ;
un diaphragme (45) s'étendant sensiblement verticalement par rapport à la ligne d'axe de tête dans le corps de tête ; et
un moyen d'ajustement de pression (60) destiné à ajuster la pression d'un fluide rempli dans une chambre de fluide (54) formée entre le diaphragme et le corps de tête, dans lequel :
le support (46) est fixé au diaphragme et est disposé de façon à pouvoir être déplacé le long de la direction d'axe de tête, pour maintenir une face de la plaquette à polir ;
la bague de retenue (47) est fixée au diaphragme et est disposée en relation concentrique entre une paroi interne de la paroi circonférentielle (44) et une circonférence externe du support (46) ; et
la poche de suspension épaisse (66) communique avec l'organe d'alimentation en suspension épaisse (61).

3. Appareil de polissage de plaquette selon la revendication 1, dans lequel la tête de maintien de plaquette comprend en outre :
un corps de tête (42) comprenant une plaque supérieure (43) et une paroi circonférentielle cylindrique (44) disposée sous une circonférence externe de la plaque supérieure ;
un diaphragme (45) s'étendant sensiblement verticalement par rapport à la ligne d'axe de tête dans le corps de tête ; et
un moyen d'ajustement de pression (60) destiné à ajuster la pression d'un fluide rempli dans une chambre de fluide (54) formée entre le diaphragme et le corps de tête, dans lequel :
le support (46) est fixé au diaphragme et est disposé de façon à pouvoir être déplacé le long de la direction de la ligne d'axe de tête conjointement avec le diaphragme, pour maintenir une face de la plaquette (W) à polir ;
la bague de retenue (47) est fixée au diaphragme tout en étant disposée en relation concentrique entre une paroi interne de la paroi circonférentielle (44) et une circonférence externe du support (46) ;
un tube de corps de tête (63) est formé dans le corps de tête et communique avec l'organe d'alimentation en suspension épaisse (61) ; et
un tube flexible (64) comprenant un organe flexible est raccordé entre le tube de corps de tête (63) et le tube de bague de retenue (65).

4. Appareil de polissage de plaquette (1, 101, 115, 201) comprenant :
une platine (P, 104, 120, 403) ;
un tampon de polissage (Su, 106, 121, 402, 182 a à c, S) fixé sur une surface de la platine ;
une tête de maintien de plaquette (71) comprenant un support (76), destiné à permettre à une face d'une plaquette (W) d'entrer au contact du tampon de polissage en maintenant la plaquette à polir, la plaquette étant polie, en utilisation de l'appareil, à l'aide du tampon de polissage par un mouvement relatif entre la tête de maintien de plaquette et la platine, une paroi circonférentielle (74) faisant partie d'un corps de tête (72), et une bague de retenue (77) qui est disposée de façon à pouvoir être déplacée le long d'une direction d'axe de tête pour verrouiller une périphérie de la plaquette tout en faisant contact avec le tampon de polissage pendant le polissage de la plaquette ; et
une bague externe (95) qui est disposée en relation concentrique par rapport à la tête de maintien de plaquette (71) et est disposée de façon à pouvoir être déplacée le long de la direction d'axe de tête, pour faire contact avec le tampon de polissage pendant le polissage à l'extérieur de la tête de maintien de plaquette (71),
**caractérisé en ce que** l'appareil de polissage de plaquette comprend en outre :
une poche de suspension épaisse (97) qui est formée entre la bague de retenue (77) et la bague externe (95), destinée à entrer au contact du tampon de polissage et à distribuer la suspension épaisse de manière égale ; et
un tube de corps de tête (93) formé dans la paroi circonférentielle (74) et communiquant avec un organe d'alimentation en suspension épaisse (91).

5. Appareil de polissage de plaquette selon la revendication 1, dans lequel la tête de maintien de plaquette (41) comprend en outre :
un corps de tête (42) comprenant une plaque supérieure (43) et une paroi circonférentielle cylindrique (44) disposée sous la circonférence externe de la plaque supérieure ;
un diaphragme (45) s'étendant sensiblement verticalement par rapport à la ligne d'axe de tête dans le corps de tête ; et
un moyen d'ajustement de pression (60) destiné à ajuster la pression d'un fluide rempli dans une chambre de fluide (54) formée entre le diaphragme (45) et le corps de tête (42), dans lequel :
le support est fixé au diaphragme et est disposé de façon à pouvoir être déplacée conjointement avec le diaphragme le long de la direction d'axe de tête, pour maintenir une face d'une plaquette (W) à polir ;
la bague de retenue (47) est disposée en relation concentrique entre une paroi interne de la paroi circonférentielle (44) et une circonférence externe du support (46) et est fixée au diaphragme, et est disposée de façon à pouvoir être déplacée le long de la direction d'axe de tête conjointement avec le diaphragme, pour faire contact avec le tampon de polissage pendant le polissage,
la bague de retenue (47) est disposée en relation concentrique par rapport à une paroi interne de la paroi circonférentielle (44) ; et
la poche de suspension épaisse (66) communique avec l'organe d'alimentation en suspension épaisse (61) par l'intermédiaire d'un tube de corps de tête (63) formé de façon à pénétrer dans une face inférieure de la paroi circonférentielle (44).

6. Appareil de polissage de plaquette (1, 101, 115, 201) comprenant :
une platine (P, 104, 120, 403) ;
un tampon de polissage (Su, 106, 121, 402, 182 a à c, S) fixé sur une surface de la platine ; et
une tête de maintien de plaquette destinée à maintenir une plaquette à polir, et destinée à permettre à une face de la plaquette d'entrer au contact du tampon de polissage, la plaquette étant polie, en utilisation de l'appareil, à l'aide du tampon de polissage par un mouvement relatif entre la tête de maintien de plaquette et la platine,
**caractérisé en ce que** l'appareil de polissage de plaquette comprend en outre :
une bague de maintien de suspension épaisse (117), qui est laissée au niveau de sa face inférieure entrer au contact du tampon de polissage, qui est disposée de façon à ne pas entrer au contact de la périphérie de la tête de maintien de plaquette et qui est disposée à l'extérieur de la tête de maintien de plaquette pour pouvoir tourner par rapport à la tête de maintien de plaquette ; et
un organe d'alimentation en suspension épaisse (119) configuré et agencé pour délivrer une suspension épaisse entre une circonférence externe de la tête de maintien de plaquette et une circonférence interne de la bague de maintien de suspension épaisse.

7. Appareil de polissage de plaquette selon la revendication 6, dans lequel un orifice de sortie (117a) destiné à évacuer une suspension épaisse vers l'extérieur est formé au niveau d'une partie d'une paroi de la bague de maintien de suspension épaisse (117).

8. Appareil de polissage de plaquette selon la revendication 6 ou 7, dans lequel un orifice de sortie (117a) destiné à évacuer une suspension épaisse vers l'extérieur est formé au niveau d'une partie d'une paroi de la bague de maintien de suspension épaisse (117).

9. Procédé de fabrication d'une plaquette comprenant :
une étape destinée à disposer une platine (P, 104, 120, 403) sur une surface de laquelle un tampon de polissage (Su, 106, 121, 402, 182 a à c, S) est fixé, une tête de maintien de plaquette (41, 71) comprenant un support (46, 76) destiné à permettre à une face d'une plaquette (W) d'entrer au contact du tampon de polissage en maintenant la plaquette à polir, et une bague de retenue (47, 77) destinée à verrouiller une périphérie de la plaquette tout en faisant contact avec le tampon de polissage pendant le polissage de la plaquette, la bague de retenue comportant un tube de bague de retenue (65) formé à l'intérieur communiquant avec un organe d'alimentation en suspension épaisse (61) ; et
une étape de polissage destinée à polir la plaquette à l'aide du tampon de polissage par un mouvement relatif entre la tête de maintien de plaquette et la platine, **caractérisé en ce que** :
une poche de suspension épaisse (66), qui est formée sur une face inférieure de la bague de retenue destinée à délivrer une suspension épaisse, est disposée à la périphérie d'une portion de maintien de plaquette sur une face inférieure de la tête de maintien de plaquette ;
la tête de maintien de plaquette peut tourner tout en permettant à la face inférieure de la tête de maintien de la plaquette d'entrer au contact du tampon de polissage ; et
la plaquette est polie en délivrant une suspension épaisse sur la face de la plaquette et une surface du tampon de polissage tout en empêchant la suspension épaisse délivrée à la poche de suspension épaisse (66) de s'écouler.

10. Procédé de fabrication d'une plaquette comprenant :
une étape destinée à disposer une platine (P, 104, 120, 403) sur la surface de laquelle un tampon de polissage (Su, 106, 121, 402, 182 a à c, S) est fixé, et une tête de maintien de plaquette (116, 160, 184, 230) comprenant un support (166, 216) destiné à permettre à une face d'une plaquette d'entrer au contact du tampon de polissage en maintenant la plaquette à polir, et une bague de retenue (167, 277) destinée à verrouiller une périphérie de la plaquette tout en faisant contact avec le tampon de polissage pendant le polissage de la plaquette ; et
une étape de polissage destinée à polir la plaquette avec le tampon de polissage par un mouvement relatif entre la tête de maintien de plaquette et la platine, **caractérisé en ce que** :
une bague de maintien de suspension épaisse (117) est disposée de façon à entrer au contact du tampon de polissage et à ne pas entrer au contact d'une circonférence externe de la tête de maintien de plaquette, et est disposée à l'extérieur de la tête de maintien de plaquette ;
une suspension épaisse est délivrée par un organe d'alimentation en suspension épaisse (119) entre la circonférence externe de la tête de maintien de plaquette et la bague de maintien de plaquette tout en permettant à la tête de maintien de plaquette de tourner par rapport à la bague de maintien de plaquette ; et
la plaquette est polie tout en empêchant la suspension épaisse de s'écouler par la bague de maintien de suspension épaisse (117).
